# EUROPEAN PATENT SPECIFICATION

(11) **EP 0 457 920 B1**
(45) Date of publication and mention of the grant of the patent: **15.04.1998**
(21) Application number: 91900363.2
(22) Date of filing: 06.12.1990
(51) Int. Cl.: B22F 1/00, B22F 9/06, B21F 11/00, B23K 35/40, B23K 35/02

(54) **METHOD OF MANUFACTURING MINUTE METALLIC BALLS UNIFORM IN SIZE**
VERFAHREN ZUR HERSTELLUNG WINZIGER METALLISCHER KUGELN GLEICHMÄSSIGER GRÖSSE
PROCEDE DE PRODUCTION DE MINUSCULES BILLES METALLIQUES DE TAILLE UNIFORME

(30) Priority: 07.12.1989 JP 320296/89; 15.02.1990 JP 35256/90; 24.04.1990 JP 109779/90; 24.04.1990 JP 109780/90; 06.07.1990 JP 179263/90; 06.07.1990 JP 179264/90; 06.07.1990 JP 179265/90; 10.07.1990 JP 183643/90; 10.07.1990 JP 183644/90
(43) Date of publication of application: 27.11.1991
(73) Proprietor: NIPPON STEEL CORPORATION, Tokyo 100-71 (JP)
(72) Inventor: MARUYAMA, Tadakatsu Daiichi Gijutsu Kenkyusho of, Kawasaki-shi Kanagawa 211 (JP); KITAMURA, Osamu Daiichi Gijutsu Kenkyusho of, Kawasaki-shi Kanagawa 211 (JP); OHNO,Yasuhide Daiichi Gijutsu Kenkyusho of Nippon, Kawasaki-shi Kanagawa 211 (JP); KIKUCHI, Toshiharu Daiichi Gijutsu Kenkyusho of, Kawasaki-shi Kanagawa 211 (JP); SUZUKI, Yasuhiro Setsubi Gijutsuhonbu of Nippon, Gashi-ku Kitakyushu-shi Fukuoka 805 (JP); KURIBAYASHI, Hisao Setsubi Gijutsuhonbu of Nippon, Gashi-ku Kitakyushu-shi Fukuota 805 (JP); UNO, Tomohiro Daiichi Gijutsu Kenkyusho of Nippon, Kawasaki-shi Kanagawa 211 (JP)
(74) Representative: VOSSIUS & PARTNER
(86) International application number: JP9001591
(87) International publication number: WO9108850

(56) References cited:
- EP-A- 134 702
- EP-A- 281 511
- EP-A- 325 660
- DE-A- 1 521 894
- DE-A- 2 261 281
- DE-B- 1 169 884
- JP-A-53 028 878
- JP-A-60 005 804
- JP-A-63 033 507
- JP-A-63 111 101
- JP-B-26 005 610
- JP-B-28 003 974
- JP-B-41 011 525
- JP-B-52 036 508
- JP-B-63 055 378
- JP-U- 1 049 333
- JP-U-56 065 929
- JP-U-61 111 634
- US-A- 3 977 069
- PATENT ABSTRACTS OF JAPAN vol. 9, no. 27521 (M-426)2 November 1985 & JP-A-60 121 063 ( TANAKA KIKINZOKU KOGYO ) 28 June 1985
- PATENT ABSTRACTS OF JAPAN vol. 7, no. 250 (M-254)8 November 1983 & JP-A-58 135 744 ( ASAHI OOKUMA SANGYO ) 12 August 1983

## Description

The present invention relates to a method of efficiently producing, with high degree of uniformity in size, fine metal spheres such as bumps which are used as bonding material in bonding methods such as TAB (Tape Automated Bonding) method or flip-chip bonding method which are used in the field of semiconductor packaging.

TAB method and flip-chip methods are known as semiconductor packaging techniques which make use of bumps. Metals such as gold are used as the material of bumps. Various shapes of bumps are used such as spherical forms, rectangular parallelopiped forms and forms intermediate between the spherical and rectangular parallelopiped forms.

Functions of the bumps are to electrically and mechanically bond two opposing electrical members. In general, the bump is placed between these two members in alignment and then heat and pressure are applied to the bump so as to bond these two members. The bump, when considered from the above-mentioned function, preferably has a spherical shape which is easy to deform. Actually, however, bumps have rectangular parallelopiped shapes in most cases. This is because that bumps of parallelopiped shapes can easily be produced by plating or etching, so that the use of bumps of such shapes are used although they are rather inconvenient to use. Plating is the most popular method for forming bumps. This method, however, involves a problem in that the purity and composition of the metal used as the material of the bump are undesirably limited, in addition to the above-mentioned problem concerning the shape.

Formation of a bump by plating is conducted either by directly plating the electrode of an IC by a bump metal which is in most cases gold of a high purity, or by forming a bump on a glass substrate by plating and then transferring the same to the end of the lead on a TAB tape.

The formation of bumps by plating, however, requires an equipment of a large scale and, in addition, suffers from restriction in the metal composition as stated above. In particular, the first-mentioned plating method which relies upon direct plating on IC chip electrodes impairs the yield of the IC chip products since the IC chips have to undergo the plating process.

As stated before, bumps of spherical shapes have not been used popularly, although the spherical shape is preferred from the view point of function. This fact is mainly attributable to difficulty encountered in the production of fine metal spheres with a high degree of uniformity in size.

Various methods have been proposed and used for forming fine metal spheres such as water atomization, gas atomization, vacuum atomization, centrifugal atomization, roller atomization, supersonic atomization, and so forth. The water atomization, however, is disadvantageous in that the metal spheres formed by this method are irregular in shape. The gas atomizing method also is disadvantageous in that it cannot produce fine spheres. The centrifugal method is suitable for producing comparatively fine spheres in an industrial scale. As described in Journal of Metals, January 1981, pp 13-18, however, the metal spheres formed by this method has a rather wide size distribution of 30 to 200 µm. In order to use metal spheres formed by this method as bumps, it is necessary to select only spheres of a specified size suitable for this purpose, by subjecting the formed spheres to, for example, sieving. Sieving the spheres in an industrial scale seriously reduces the yield and, hence, is quite impractical. These are the reasons why no positive attempt has been made to put spherical bumps into industrial use.

EP-A-0 325 660 describes a method of heat treatment of a low melting-point metal for producing spheroidal bodies formed of a low melting-point metal or alloy or heat treatment of the low melting-point metal for treating the surface of an electrode. The method comprises the steps of placing a high boiling-point liquid into a tubular container with a temperature gradient ranging from a high temperature above the melting point of the metal to be subjected to the heat treatment to a low temperature below the melting point thereof, thereby allowing a melt or a molten portion of a metal or alloy being moved through these portions to solidify to balls.

JP-A-60121063 describes a manufacturing method of a lead pin with a spherical brazing filler metal. The brazing filler metal is made into a fine wire which is cut to manufacture a granular piece. A plurality of pieces are arrayed on a carbon tray and are melted by heating in a furnace kept under a non-oxidizing atmosphere. The molten pieces are solidified to obtain spheres of tie brazing filler metal. A lead pin is inserted into the hole of a carbon jig and the sphere of the brazing filler metal is set at the top end thereof. The jig is heated to the temperature higher than the solidus line temperature of the brazing filler metal and lower than the liquidus line temperature in the furnace kept under the non-oxidizing atmosphere and is then cooled. The sphere of the brazing filler metal is securely joined to the pin.

Accordingly, an object of the present invention is to establish a method which enables an efficient production of fine metal spheres with such high degrees of uniformity in size and shape as to enable these spheres directly as bumps in semiconductor packaging process, without suffering from restriction in purity and composition of the sphere material and without necessitating any classification such as sieving.

This object is achieved with a method according to the claims.

There is provided a method of producing fine metal spheres with a high degree of uniformity in size, having the steps of cutting an ultra-fine metal wire into chips of a predetermined length, and heating the chips to a temperature higher than the melting point of the chip thereby spheroidizing the chips.

One of the most critical requirement for producing bumps with a uniform size is to cut the ultra-fine metal wire exactly at a constant length. Obviously, the precision of the cutting length can be enhanced by minimizing the diameter of the ultra-fine wire and selecting a comparatively large cutting length. In general, a bump has an extremely small size, e.g., 100 microns or below in diameter. The cutting length is usually 0.5 mm or less and 1 mm at the largest, however the wire diameter may be reduced. In addition, metals suitable for use as a bump material are usually soft so that ultra-fine wires formed from such metals are easily deformed by, for example, the force of gravity. Ultra-fine wires of such soft metals are obviously non-stiff, so that a difficulty is encountered in feeding the wires in such a manner as to feed such wires without any bend.

Thus, one of the critical features of the present invention resides in that ultra-fine metal wires are precisely cut at a constant length.

Another critical feature is that the chips cut from the ultra-fine metal wires are heated to a temperature above the melting point so as to be spheroidized. A description will be given of this critical feature. In general, molten metal exhibits a large surface tension, so that a fine solid metal heated to a temperature above the melting point naturally tends to form a sphere. From a theoretical point of view, therefore, it is possible to form a metal sphere by preparing a metal solid of the same mass as that of the sphere to be formed, melting the metal solid and then slowly cooling the melt to allow it to solidify.

Needless to say, thee is a limit in size at which the force of gravity exceeds the surface tension to thereby make the sphere to have a flattened form. Flattening by the force of gravity, however, does not cause any problem in the invention because the influence of the force of gravity is materially negligible due to extremely small size of the spheres, e.g., 0.5 mm or smaller.

The present inventors have made an intense study to develop a method which would enable an efficient production of fine melt spheres by using the above-described principle, and examined conditions for putting the production method to a practical industrial use. As a result, the inventors have found that the following conditions (1) to (5) are most critical.
(1) Spheres of a constant size is obtainable if the volume of the material pieces is constant, even when the material pieces have irregular forms. The use of a wire as a blank material is therefore preferred because it enables an easy preparation of a large quantity of material pieces of a constant mass. Namely, a large quantity of material pieces of a mass can easily be prepared simply by cutting a wire at a constant pitch, provided that the wire has a constant cross-sectional area. The cross-sectional area is preferably minimized to minimize any fluctuation in the mass caused by error in the cutting length and, hence, to further enhance the dimensional precision.
(2) When a wire is used as the blank material, it is necessary that the ratio of the length of the chip cut from the wire to the cross-sectional size of the same is carefully selected because, when the ratio is too large, the chip may be divided into two metal spheres when molten by heating. Although the melt wire chip preferably has a large length while the cross-sectional size is minimized from the view point of the condition (1) above, it is preferred that the above-mentioned ratio falls within a certain range, considering the second condition, i.e., formation of one metal sphere from one wire chip. Through an intense study, the inventors have found that the tendency for the metal wire chip to be divided into two spheres is reduced to a satisfactory level when the length of the metal wire chip does not exceed 100 times the diameter of the same, when the blank wire has a circular cross-section. Taking into account also the dimensional tolerance, therefore, it is preferred that the ratio of the length to the diameter of the metal wire chip ranges between 5 and 100, and more preferably between 5 and 50.
(3) It is necessary that adjacent metal wire chips have to be spaced by a minimum distance during melting, for otherwise molten chips may merge in each other to form a greater spheres than expected. In addition, the metal wire chips may be deformed by application of heat. In order to avoid such a problem, it is necessary that the metal wire chips are spaced by a predetermined distance, hopefully 1 mm or greater.
(4) The surfaces of the metal wire chip may be oxidized or part of the chip may be dissipated by evaporation during the heating. This causes undesirable effect such as reduction of the yield due to contamination of the bump surface which is strictly required to be clean. It is therefore necessary to take a suitable anti-oxidation measure for certain kinds of metal. When the metal used has a high vapor pressure, it is also necessary that the melting is conducted in an atmosphere of an inert gas so as to prevent evaporation.
(5) The temperature to which the metal wire chip is heated only needs to be higher than the melting point. Heating to an unnecessarily high temperature is preferably avoided in order to prevent any change in the metal composition or degradation of the bump surface. The inventors have confirmed that the heating temperature is preferably 0 to 100°C higher than the melting temperature of the metal. To be more precise, it is preferred that the heating temperature is selected to be low when the size of the metal sphere to be obtained is small. When heating to a comparatively high temperature is unavoidable, it is necessary to minimize the period in which the metal wire chip is held at such a high temperature, thereby preventing evaporation. In such a case, it is also preferred that the rate of cooling to re-solidification is increased to prohibit growth of coarse dendrite, thereby preventing degradation of the surface state.

Fig. 1 is an illustration of a first embodiment of the method in accordance with the present invention, showing chips cut from a fine metal wire and arrayed on rows on a flat bottom of a crucible;
Figs. 2A and 2B are illustrations of processes for cutting a wire into a large quantity of chips of a predetermined length;
Fig. 3 is a graph showing distribution of sizes measured on metal spheres produced in accordance with the first embodiment;
Fig. 4 is a schematic illustration of a cutting step in a second embodiment of the present invention;
Fig. 5 is a schematic illustration of a modification of the second embodiment;
Fig. 6 is a schematic illustration of another modification of the second embodiment;
Figs. 7, 8a and 8b are illustrations of a cutting operation in a third embodiment of the present invention;
Figs. 9a to 9f are illustrations of a cutting operation in a fourth embodiment of the present invention;

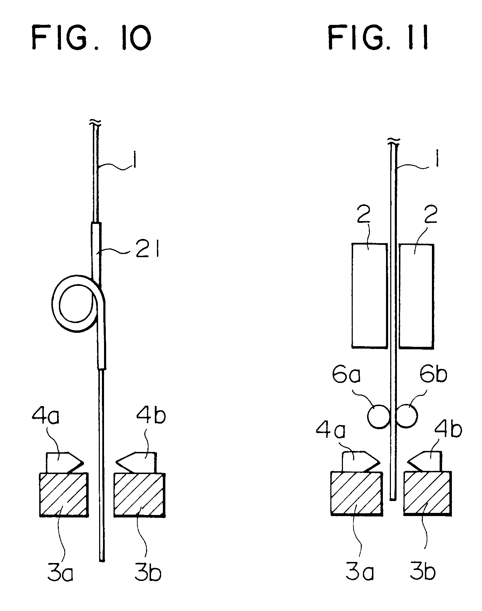

Fig. 10 is an illustration of a modification of the cutting operation shown in Figs. 9a to 9f, obtained by replacing a part of the device of Figs. 9a to 9f with an alternative;
Fig. 11 is a schematic illustration of another modification which employs feed rolls;
Fig. 12 is an illustration of a further modification which is improved to provide a higher cutting efficiency;
Fig. 13 is a schematic illustration of a cutting device used in a fifth embodiment of the present invention;
Fig. 14 is a schematic fragmentary enlarged view of the cutting device of Fig. 13, showing particularly a cutting roller cutting a fine metal wire;
Fig. 15 is an enlarged schematic illustration of a roller in a modification of the cutting device used in the fifth embodiment;
Fig. 16 is an enlarged schematic illustration of a roller in another modification of the cutting device used in the fifth embodiment;
Fig. 17 is a schematic illustration of a device which is used in a heating step in a sixth embodiment of the present invention;
Fig. 18 is a schematic illustration of a device which is used in a heating step in a seventh embodiment of the present invention;
Fig. 19 is a schematic illustration of a device used in a modification of the seventh embodiment;
Fig. 20 is a schematic illustration of a device which is used in a heating step of an eighth embodiment of the present invention;
Fig. 21a is a schematic illustration of a base plate and a pressing cover used in a ninth embodiment of the present invention in which cutting and melting are conducted simultaneously;
Fig. 21b is a schematic side elevational view of the base plate and the pressing cover which are brought together;
Figs. 22 and 23 are illustrations of a method for stretching fine metal wires on the base plate in the ninth embodiment;
Fig. 24 is illustration of the base plate of Figs. 22 and 23, on which the fine metal wires are stretched, and a presser cover fixed thereto.
Figs. 25 and 26 are illustrations of a presser lid used in the ninth embodiment;
Figs. 27 and 28 are illustrations of different examples of the base plate used in the present invention;
Fig. 29 is an illustration of a modification of the ninth embodiment in which three base plates are used in stack; and
Fig. 30 is an illustration of a modification of the ninth embodiment in which fine metal wires are beforehand prepared in a wave-like form to eliminate the necessity for a cover.

### [First Embodiment]

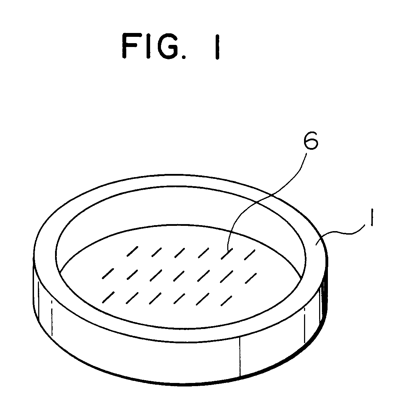

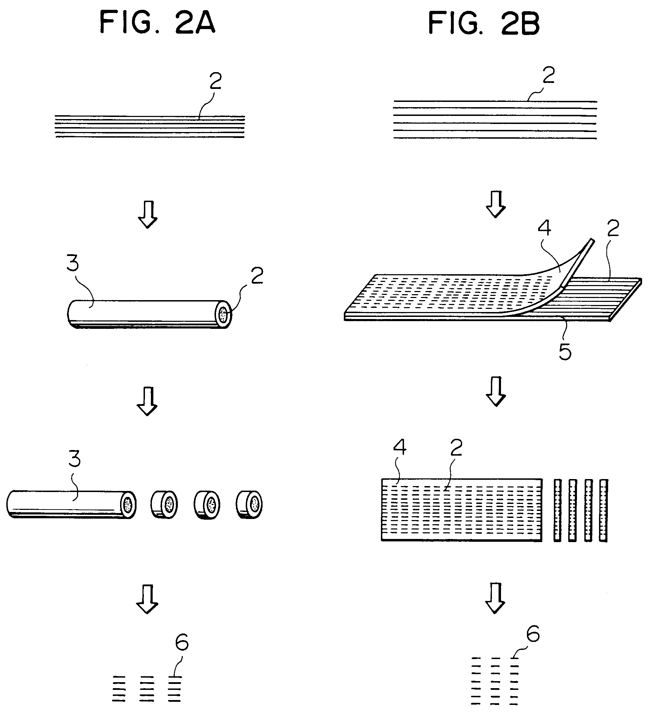

A first embodiment, which will be described with reference to Figs. 2A and 2B, is effective in cutting a fine wire at a high precision without allowing any slack of the fine wire. More specifically, in the method shown in Fig. 2A, a bundle of tone metal wires is enclosed in a sheath 3 of a resin such as vinyl chloride. The bundle with the sheath is then cut into pieces of a constant length and then the sheath of each piece is broken, whereby metal wire chips 6 of a predetermined length are obtained. This method, however, involves a risk in that, when a too large number of wires are bundled, precision of the cutting length may be impaired due to bend or twist of independent wires in the sheath. Fig. 2B shows a method in which a multiplicity of metal wires 2 are laid in parallel and sandwiched between two tapes 4 and 5, and this sandwich structure is cut at a predetermined width. Metal wire chips of a predetermined length are then obtained as the tapes are separated. In this method, at least one of the tapes should be an adhesive tape. The other tape need not always be adhesive. Namely, the covering tape may be a sheet of paper or the like. With this method, it is possible to obtain metal wire chips with an automatic cutting apparatus having a wide cutting blade. The metal wire chips 6 thus obtained are arrayed on a crucible 1 made of a material which is not reactive with the metal of the wire chips, as shown in Fig. 1. Fine metal spheres could be obtained with a high degree of uniformity in size, by heating these melt wire chips in the crucible.

Cutting of the metal wires into chips could be conducted with a very small error of ±0.1 mm or less by a commercially available automatic cutting device. Fine metal wire chips cut at the predetermined length were placed at a spacing greater than a predetermined limit value, in a crucible made of a material having a small wettability to the wire metal, e.g., graphite, and were heated in vacuum or an atmosphere of an inert gas. As a result of the heating, the wire chips were molten and became spheres due to action of the surface tension. After all the metal wire chips were molten, the spherical melts were cooled to solidify without loosing their spherical shapes, whereby the fine metal spheres as the product were obtained. Working Examples of the first embodiment are shown below.

### Working Example 1

Copper wires of 0.1 mm dia. were cut into wire chips of 0.7 mm long, and the fine copper wire chips thus obtained were placed on a flat bottom of a ceramics crucible at a pitch of 2 mm or so, followed by heating at 1120°C in a vacuum furnace.

The copper spheres this obtained were measured. The spheres had a mean diameter of 0.22 mm, with the maximum and minimum diameters of 0.24 mm and 0.21 mm, thus proving a high degree of uniformity of the size.

### Working Example 2

Ten gold wires of 46 µm dia. were bundled and clad in a sheath of vinyl chloride as shown in Fig. 2A. A plurality of clad bundles of gold wire were chopped by an automatic cutter into pieces of 0.5 mm long. After the cutting, the sheath of vinyl chloride was removed and gold wire chips of an equal length were taken out. The gold wire chips thus obtained were laid in a graphite crucible having a flat bottom at a pitch of about 1 mm, and the crucible was put in a vacuum chamber for heating at 1080°C by induction heating method.

About 9000 gold spheres thus obtained were sieved with a #120 mesh standard sieve (mesh aperture size 125 µm). All the gold spheres passed this sieve. The gold spheres were then screened through a sieve of #140 mesh (aperture size 106 µm). None of the gold spheres passed this sieve. Diameters of 100 spheres extracted from about 9000 spheres were measured. The mean diameter wan 117 µm and the standard deviation was 1.9. From the results of the sieving and measurement, it is understood that the diameters of the gold spheres produced by this Working Example falls within a very restricted range between about 111 and 123 µm.

### Working Example 3

15 (fifteen) gold wires of 25 µm diameter were adhered to an adhesive tape of 18 mm wide in parallel and at a pitch of 1 mm, in a manner shown in Fig. 2B. A paper tape of the same width as the adhesive tape was adhered to the adhesive tape, such that the wires are sandwiched between the adhesive tape and the paper tape. This sandwich structure was sliced by an automatic slicer at a constant width of 0.55 mm. Thus, each slice of the sandwich structure had 15 gold wire chips of the constant length of 0.55 mm. The slices with the tapes were placed in a graphite crucible and heated at 500°C in atmosphere to burn the tapes. Then, after changing the atmosphere to vacuum, the gold wire chips were heated to 1170°C by induction hating. Numerous gold spheres with uniform size were thus obtained after removal of the residue of the burnt tapes. In Working Example 3, the heating was conducted in two stages. The first stage, which was conducted for the purpose of burning the tapes in atmospheric air at a low temperature, is not essential but is preferably adopted particularly in the case where the material metal has such a high reactivity as to react with the impurities in the tape material and to avoid any reaction between such impurities and the crucible surface.

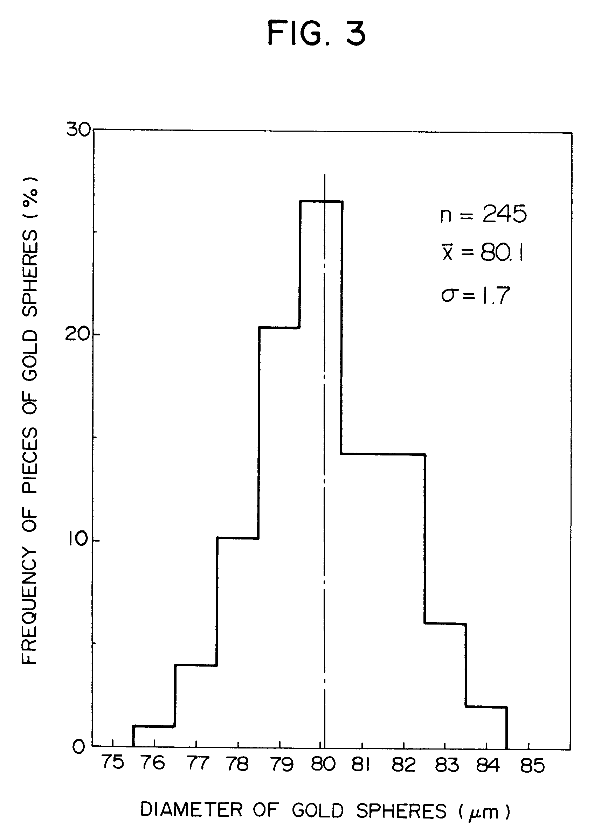

Diameters were measured on 245 samples extracted from the gold spheres thus obtained, the result being shown in Fig. 3. It will be seen that the diameters of all the sample spheres ranged between 76 µm and 84 µm and the mean diameter is 80.1 µm with a standard deviation of 1.7, thus proving high degree of uniformity of the sphere size.

Metal spheres formed by conventional mass-producing method have a wide size distribution. In order to select spheres of a specified range of size, therefore, it has been necessary to classify the spheres by, for example, sieving, so as to remove spheres which do not fall within the specified range of diameter. According to the first embodiment of the invention as described, it is possible to mass-produce, without requiring sieving, metal spheres with such a high degree of uniformity in size as to enable the spheres to be directly applied to uses which strictly require high dimensional precision, e.g., bumps, simply by cutting blank melt wires into chips exactly at a constant length. Furthermore, there is no restriction in the composition and purity of the metals which are encountered in the production of bumps by plating, thus allowing a wide selection of the metals and alloys in accordance with the nature or purposes of use of the spheres.

The present invention is basically intended for the production of metal spheres with high degree of uniformity of size. However, the invention can be applied to production of spheres of any desired size distribution, by providing a predetermined distribution of the cutting length.

### [Second Embodiment]

The first embodiment is very effective when an ultra-fine metal wire as a bump material is precisely cut by a known cutting device having a constant-pitch feeding mechanism. The first embodiment is suitable for small-scale productions.

In a second embodiment of the present invention which will be described hereinunder, a blank material of a soft metal such as gold, drawn to an ultra-fine wires of 50 microns or smaller diameter, is cut into a large quantity of chips of a constant length of 1 mm or less, preferably 0.6 mm or less, efficiently and with a high precision of cutting length, by using means which avoid any possibility of contamination of impurities such as adhesive components or components of arraying material.

Obviously, an efficient production of fine metal wire chips by cutting requires a simultaneous cutting of ultra-fine metal wires or, if only one wire is to be cut, a cutting method which provides an extremely high cutting speed. The second embodiment is based upon the first-mentioned method, i.e., simultaneous cutting of a plurality of ultra-fine wires bundled or arrayed in parallel. When a sheath, adhesive or tapes are used over the entire length of the ultra-fine wires for fixing these wires in parallel, the materials of the sheath, adhesive or tapes are concurrently cut to require a troublesome work for removing these inclusions. In order to eliminate this problem, the second embodiment makes use of an adhesive or tape which are applied only to both longitudinal ends of the parallel ultra-fine wires, so that no foxing material is applied to intermediate portions of the ultra-fine wires.

This method, however, excludes any cutting method which cuts the wires form one towards the other ends. Namely, since the parallel arrangement of the ultra-fine wires is maintained by the supports at both ends thereof, the array will be loosened and when the wires are cut at their one ends. A similar problem is encountered when the flatness of the upper surface of the base plate is insufficient. The base plate, therefore, should be used in a clean state without any fine dust left on the upper surface thereof. In order to cut the ultra-fine metal wires into chips of a constant length while the wires are supported in such an unstable manner, it is desirable and effective that the cutting be conducted at once at all points where the cutting is necessary.

The second embodiment, therefore, is a result of a study for establishing a method which enables the cutting of intermediate portions of ultra-fine metal wires at once at all points where the cutting is necessary. As a result of the study, the inventors have found that such an object is easily attained by using a special cutting jig composed of a stack of cutting blades having disk-like or linear cutting edges. Namely, ultra-fine metal wires stretched on a flat base plate made of, for example, a hard rubber could be cut in a short time into chips of the desired length by means of a cutting jig having cutting edges which are arranged linearly at a constant pitch corresponding to the length of the chips to be obtained.

In this embodiment, attention must be paid to the following points.

It is necessary that the degree of parallel of the ultra-fine fibers laid on the flat base plate has to be sufficiently high to minimize error of the cutting length which may occur when the wires are not parallel. The cutting precision also tends to be impaired due to, for example, deformation at the cut edge, when the ultra-fine metal wires are placed in two or more layers on the base plate. Therefore, it is preferably avoided to stack to many ultra-fine metal wires. This applies also to the case where a plurality of ultra-fine metal wires are bundled.

In this embodiment, it is necessary that all the cutting edges are simultaneously brought into contact with the portions of the single ultra-fine metal wire along the length of the wire. If there is any difference in the timing of cutting by different cutting edges, the ultra-fine metal wire will undesirably spring when the wire is cut by the first cutting edge, so that subsequent edges cannot cut the wire precisely. It is, therefore, necessary that all the cutting edges are held at the constant level. When a cylindrical cutting jig is used, attention must he paid to keep the axis of the jig strictly in parallel with the stretched ultra-fine metal wire. When a flat tabular cutting jig is used, it is necessary that the plane formed by the ends of the cutting edges is held in parallel with the upper surface of the base plate or, at least, that the direction in which the edges of the cutting jig are arrayed in parallel to the longitudinal direction of the ultra-fine metal wires to be cut.

As the first step of this embodiment, the desired number of the ultra-fine metal wires to be cut are arrayed on a flat base plate. The fixing of these wires is done by applying an adhesive, tapes or sheaths only to both ends of these wires. Thus, the fixing means is not at all applied to intermediate portions of the ultra-fine wires. Consequently, the fixing material is not mixed in the ultra-fine wire chips after the cutting, thus eliminating any unfavorable effect which may otherwise be caused by impurities in the subsequent melting step.

Furthermore, since all the portion of the intermediate parts of the ultra-fine metal wires to be cut are cut simultaneously by a jig having a plurality of disk-like or linear cutting edges, it is possible to obtain a large number of ultra-fine metal wire chips of the constant length simply by arraying the ultra-fine metal wires and fixing them only at their both ends.

Preferably, the flat base plate on which the ultra-fine metal wires are laid is made of a material having a fine structure and having a certain degree of elasticity, such as a hard rubber, plastics and so forth. The base plate made form such a material does not unnecessarily damage the cutting edges so that the cutting jig can stand a long use.

### Working Example 1

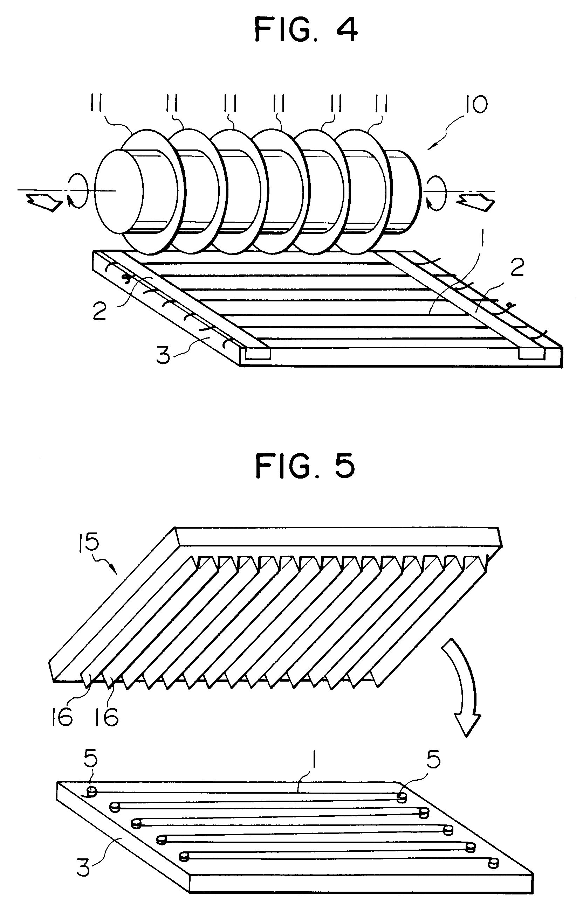

Fig. 4 is a perspective view schematically showing a cutting operation conducted in accordance with this embodiment. Gold wires of 30 µm dia., used as the blank ultra-fine metal wires 1, were placed on a hard rubber plate serving as the base plate 3. These gold wires were fixed only at their both ends by means of adhesive tapes 2 bonded to the hard rubber plate. A cylindrical cutting jig 10, having a multiplicity of disk-like cutting edges 11 arranged at a pitch of 0.55 mm, was rolled on the top surface of the hard rubber from one end of the hard rubber plate towards the other end, whereby ultra-fine gold wires on the hard rubber plate were cut at a length of 0.55 mm.

The gold wire chips after the cutting were placed in a graphite crucible so as not to contact each other, and were high-frequency heated, whereby gold spheres for use as bumps were obtained with a high degree of uniformity in size and without any impurity.

### Working Example 2

The concept of Working Example 2 will be described with reference to Fig. 5.

A plurality of small projections 5 were provided on both ends of a hard rubber plate used as the flat base plate 3. A continuous ultra-fine metal wire was stretched by being turned around the projections on alternating ends of the base plate 3, whereby a plurality of runs of the ultra-fine metal wires were arranged at a constant pitch. In this case, a gold wire having a diameter of 25 µm was used as the ultra-fine metal wire. A small amount of adhesive was applied to the portions of the ultra-fine gold turning around the projections so as to temporarily fix the wire. A cutting jig 15 was used in which a multiplicity of razor blades 16 were arrayed such that cutting edges of the blade form a flat plane. The cutting jig 15, while being held in horizontal posture, was moved downward onto the hard rubber plate 3 on which the gold wires 1 were stretched, whereby the ultra-fine gold wires were cut at plurality portions over the entire length substantially simultaneously. The gold wire chips after obtained as a result of the cutting were molten by the same method as the first working example, thus forming clean fine gold spheres suitable for use as bumps.

### Working Example 3

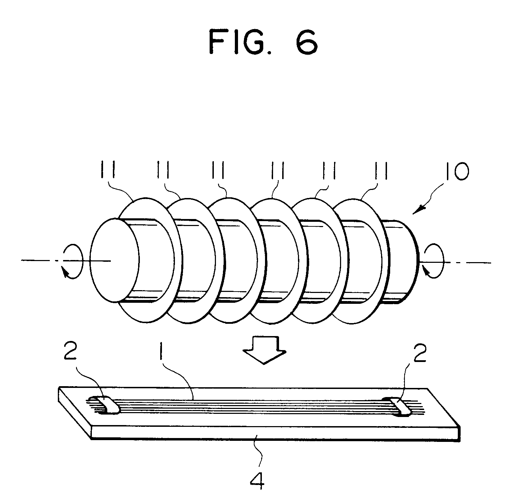

Referring to Fig. 6, a multiplicity of ultra-fine metal wires 1 (gold wires of 25 µm dia.) were bundled and fastened together at their both ends. The bundle was laid on a polypropylene plate serving as a flat base plate 4 without any slack. Both ends of the bundle fastened by adhesive were fixed to the base plate 4 by means of adhesive tapes 2.

A cutting jig 10 which is the same as that used in Working Example 1, i.e., jig having disk-like edges 11 arranged at a pitch of 1 mm, was rotated and lowered towards the polypropylene plate on which the bundle of the ultra-fine metal wires was fixed.

The gold wire chips obtained through the cutting were molten by the same process as the first embodiment, whereby fine gold spheres optimum for use as bumps were obtained.

Thus, in the second embodiment of the present invention, ultra-fine metal wire chips, suitable for use as the material of bumps used in, for example, TAB method, can be obtained in a very large lot without mixing of impurities. In consequence, the troublesome work for removing impurities of ultra-fine metal chips before melting is eliminated to enable a very efficient production of bumps.

### [Third Embodiment]

This embodiment provides a cutting method in which fine metal wire chips of a constant length, which are to be molten to form bumps, can be cut from fine metal wires in a large lot by a cutting means which excludes any possibility of mixing of impurities such as components of adhesive or fixing material and which can supply the cut fine metal wire chips to a subsequent melting step without allowing these chips entangle with one another.

In a first cutting method used in this embodiment, a fine metal wire is fed through a guide having a minute inside diameter and, when the wire is fed out of the outlet end of the guide by a predetermined length, a cutting blade provided in the vicinity of the guide is activated to cut the fine metal wire.

In a second cutting method used in this embodiment, two types of guides are used: a guide X having an inside diameter just for allowing a fine metal wire to pass therethrough and a guide Y having an inside diameter slightly greater than that of the guide X. When a fine metal wire advanced through the guide X is received at its leading end by the guide Y by a predetermined length, a relative movement is caused between these guides so that a shearing is effected by the opposing edges of both guides, whereby the fine metal wire is cut.

This embodiment is intended for cutting fine metal wires having diameters 50 µm or smaller. The fine metal wire chips thus formed by cutting are arrayed in such a manner as not to be entangled with one another and are molten to form spherical bumps. The cutting step, therefore, should not be considered alone but should be considered from the view point of ease of melting in the next step.

In the melting step, attention must be paid above all to exclude any impurity, not only impurities which tend to be melt in the metal as the bump material but also impurities which tend to attach to the bump surfaces. Needless to say, such impurities should be removed before the metal chips are heated to a high melting temperature, rather than after the formation of the bump spheres.

In the method of the first embodiment for example, fixing means such as tapes are used for foxing the fine metal wires, a sorting operation has to be conducted before the melting for removing impurity sources such as the tape pieces after the cutting of the wires into fine metal wire chips, unless such impurity sources are of a type which can completely be extinguished by burning during the heating. Such a sorting operation is extremely difficult to conduct. It is therefore highly desirable that the cutting step is completed without using the impurity sources such as tapes and adhesive. It is also necessary that the independent metal wire chips are brought to the melting step without being interfered by one another. If a plurality of metal wire chips contacting one another are brought to the melting step, the melts of these chips will merge together to form large bumps which are practically unusable.

Thus, the third embodiment is mainly aimed at providing a cutting method for cutting fine metal wires in such a manner as to exclude mixing of impurities and, hopefully, to facilitate control of spacing of the metal wire chips falling into a receiver.

In order to achieve this aim, it is necessary that an independent fine metal wire, without any treatment, is cut at a high speed and the severed fine metal chips are evenly received by a receiver. By momentarily moving the receiver, it is possible to avoid concentration of the wires to local portions on the receiver.

The following two methods are conceivable as the method of cutting independent fine metal wires. In a first method, a guide is used which has a nozzle-like bore of a small diameter just for allowing the fine metal wire to pass therethrough. The fine metal wire fed through this guide is cut by a cutting tool which is disposed in the close proximity of the outlet of the guide. In a second method, the above-mentioned guide is used as a guide X, in combination with another guide Y having a bore slightly greater than the bore of the guide X. These guides are arranged to oppose each other and, when a fine metal wire fed through the guide X is received in the guide Y by a predetermined distance, a shearing is effected between the opposing edges of the guides thereby to shear the fine metal wire. The first method requires a cutting tool disposed on the outlet side of the guide. The cutting tool, preferably has a cutting blade of a very small thickness such as that of a razor since it is required to cut the wire into chips of an extremely small length. The material of the guide should be selected to enable the guide to stand a long use. In particular, in the second cutting method, it is preferred to use ceramics or a hard alloy because the cutting is effected by the shearing caused by the sliding between the ends of two guides.

The fine bore of the guide should have a diameter which is just for allowing the fine metal wire to pass therethrough. The clearance between the fine metal wire and the wall of the bore depends on the kind of the metal but should be on the order of several %. The diameter of the bore in the guide Y, however, is preferably determined to be about twice the diameter of the fine metal wire, in order that the leading end of the fine metal wire, which may have been deformed by the preceding cutting, can be slided into the bore without being interfered by the brim of opening of this bore.

The fine metal wire is cut at a position in the close proximity of the guide, by the shearing effect produced by the cutting blade or the other guide. The cut wire chips are ejected separately and independently so that they can be delivered to the subsequent melting step in a good order.

### Working Example 1

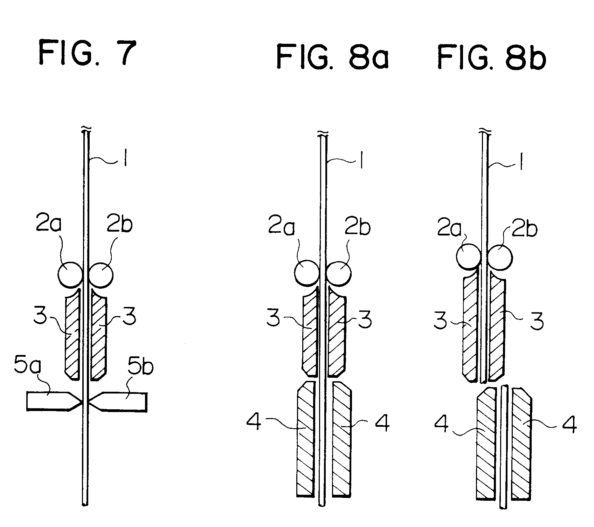

Fig. 7 is a schematic illustration of a cutting method used in the third embodiment of the invention. A gold wire of 30 µm diameter was used as the blank fine metal wire 1. Grooved ceramic rolls were used as feed rolls 2a, 2b. These feed rolls 2a, 2b are driven by stepper motors (not shown) so as to advance the fine metal wire 1 through a fine bore in a guide 3 to a position where cutting blades 5a, 5b are stationed. The guide 3 was made of ceramics, while worked razor blades were used as the cutting blades. The length of each feed effected by the feed rolls is controlled by a driving unit (not shown) so as to be equal to the length of the cut metal wire chips to be obtained. In this Working Example, the driving unit was set to feed the wire at a pitch of 0.6 mm.

Needless to say, the cutting blades 5a and 5b are spaced apart from each other while the feed rolls are rotating to fed the fine metal wire 1. When one cycle of feed is completed, the cutting blades are activated to perform one cycle of cutting operation and then set again at the stand-by position. After the feed rolls conduct the next cycle of the feeding operation, the cutting edges are activated again to conduct the second cycle of the cutting operation. Cutting operation is thus conducted sequentially so that the cut fine metal wire chips are allowed to drop independently of one another.

In this Working Example, a graphite crucible with a flat bottom is placed at a position where it can receive the falling cut wire chips and the position of the crucible is momentarily shifted upon each receipt of a cut wire chip. The crucible on which the cut wire chips are placed can directly be put in a melting furnace, whereby bumps can be produced at a high efficiency.

In this Working Example, cutting is effected by a pair of cutting blades which pinch the wire from opposite sides thereof. This, however, is only illustrative and the cutting may be effected from one side of the wire by making use of a rotary blade.

### Working Example 2

The concept of the second cutting method used in the third embodiment will be described with reference to Figs. 8a and 8b. This cutting method, for cutting a fine metal wire 1, employs feed rolls 2a, 2b and a guide 3 which are the same as those used in the first cutting method described in connection with Working Example 1. This Working Example features the use of a guide 4 in place of the cutting blades disposed under the guide 3 in Working Example 1. The fine metal wire 1 used in this Example had a diameter of 20 µm and the fine bore in the guide 3 had a diameter of 25 µm. The diameter of the bore in the guide 4 was 40 µm. Both guides were made of ceramics.

As the first step, the fine metal wire 1 is threaded both through the guide 3 and the guide 4, as shown in Fig. 8a. Then, the lower guide 4 is laterally moved by 0.5 mm relative to the guide 3, so that the fine metal wire is cut by shearing. After the cutting, the guide is reset to the initial position and then the fine metal wire is fed by the feed rolls into the guide 4. As the fine metal wire is fed into the guide 4 by a predetermined length, the feed rolls are stopped automatically and then the guide 4 is laterally moved to cut the fine metal wire.

By this method, a fine metal wire could be cut into chips with a high degree of precision of the cutting length.

Thus, according to the third embodiment, it is possible to obtain fine metal wire chips which are to be molten to form bumps used in TAB method for example, in a large lot without allowing mixing of impurities, thus eliminating necessity for a work for removing impurities in advance of the subsequent melting step, while avoiding merging of a plurality of molten metal chips into a large sphere, thereby offering a highly efficient production of bumps.

### [Fourth Embodiment]

This embodiment employs a cutting method which is different from that used in the third embodiment and in which a blank fine metal wire of a soft metal such as gold, which is drawn to a very small diameter of 50 microns or less suitable for production of bumps, is cut into a large number of chips of the desired length, at a high frequency and a high precision of cutting length, by cutting means which excludes any impurity such as components of adhesive or fixing material, while preventing mutual entanglement of the cut fine metal chips.

Two types of cutting methods are used. In a first cutting method, the leading end of a gripper which grips an end of the fine metal wire is moved to extract the wire from a guide by a predetermined distance and, then, cutting device provided in the close proximity of the gripper is activated to cut the fine metal wire.

In a second cutting method, a fine metal wire is extracted by a predetermined length from a guide by means of feed rolls which are arranged on the outlet side of the guide and, thereafter, a cutting device disposed in the close proximity of the feed rolls is activated to cut the fine metal wire.

This embodiment features a specific way of cutting, the cut metal wire chips are arrayed in such a manner as not to interfere with one another and then delivered to the melting step to become spherical bumps. Thus, the cutting conditions should be considered not on the basis of the cutting operation alone but should be considered also from the view point of ease of the subsequent melting operation.

This embodiment, therefore, is aimed at providing a cutting method which meets the first requirement of exlusion of mixing of impurities and the second requirement for prevention of entanglement of the cut metal wire chips. in such a manner as to facilitate the control of spacing of the cut metal wire chips fallen on the receiver. To achieve this aim, it is necessary that an independent bared fine metal wire is cut bit-by-bit and the cut metal wire chips thus formed successively are processed one by one.

A metal wire of an ordinary diameter can easily be cut into a multiplicity of chips of a constant length, by intermittently pushing the wire by feed rollers and activating a cutting device in each interval of the feed. In case of a fine metal wire having an extremely small diameter, however, the feeding precision itself tends to be impaired due to flexing of the wire pushed by the feed rolls. It has become clear that this problem can be overcome by extracting the wire through a guide. The following methods were found effective for intermittently extracting a fine metal wire at a constant pitch.

The first method employs a holding means such as a gripper which grips part or whole of the leading end portion of the fine metal wire which is to be severed. The holding means is moved away from the guide by a distance corresponding to the length of the metal wire chips to be severed, thereby extracting the fine metal wire. The second effective method employs feed rolls arranged at the outlet side of the guide. The feed rolls are driven by, for example, stepper motors one step of which corresponds to the length at which the fine metal wire is to be cut. According to these methods, troubles such as bending of the fine metal wire, which is caused when the fine metal fire is fed by pushing forward, is eliminated. In addition, a tendency for the fine bore of the guide to be clogged with the fine metal wire is greatly suppressed.

Mechanisms for extracting a fine metal wire at a constant pitch are thus realized. The inventors have conducted a study to find a cutting method suitable for combination with the described feeding method. In order to attain a high precision of the cutting length, it is necessary that the cutting blades are activated while the portion of the wire as near as possible the cutting blades is firmly fixed. If the wire is fixed at a position spaced from the cutting blades, the fine metal wire is largely moved by the movement of the blade itself, with the result that the cutting precision is impaired correspondingly. In addition, the fixing portion should be determined to be as close as possible to the end of the fine metal wire. Further it is preferred to grasp an extreme end of the fine metal wire, which is going to be severed, at the outside position of the blade rather than a position intermediate between the guide and the cutting blades. In such a case, the portion of the fine metal wire, which has been deformed by the gripper, is severed off the wire and the gripper can grip a new portion of the wire which has not been substantially affected by the previous gripping and cutting. Such an arrangement of the holding means, therefore, remarkably enhances the reliability of an automatic system which performs the method of this embodiment.

The fine metal wire to be cut is intermittently extracted from the outlet side of the guide. The length of extraction in each extracting cycle corresponds to the length of the cut metal wire to be obtained. The extraction is conducted by the feed rolls or the holding means provided on the outlet side of the guide. The cutting is conducted by cutting blades which are arranged in the close proximity of the feed rollers or holding means. Cutting operation suitable for mass-production was successfully executed without causing any bend of the fine metal wire in the guide bore or clogging of the bore by the wire, by virtue of the fact that the fine metal wire was extracted from the outlet side of the guide rather than by being pushed into the tiny guide bore.

### Working Example 1

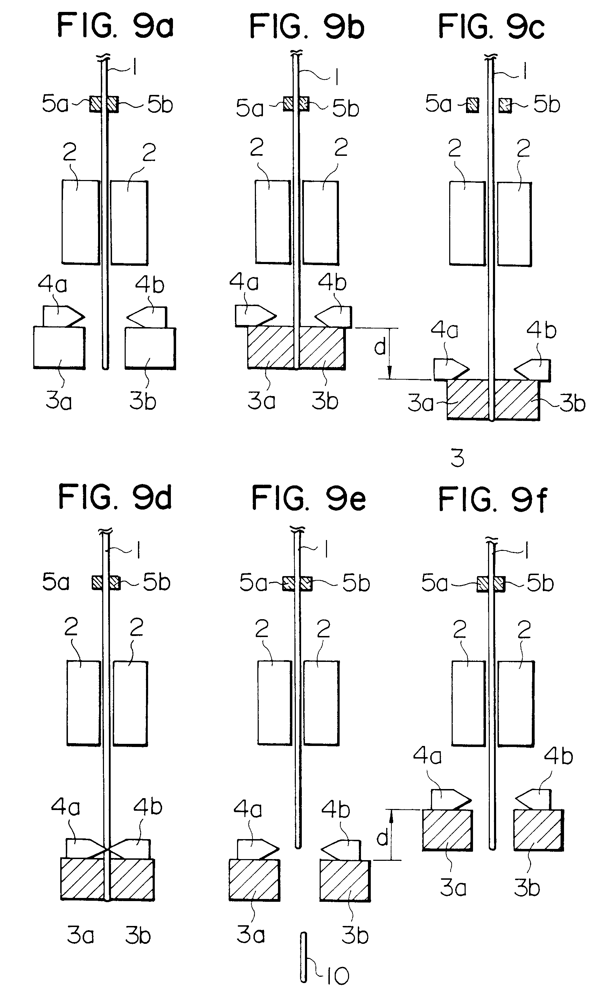

Figs. 9a to 9f schematically show basic operation of this embodiment. A gold wire of 20 µm dia. was used as the fine metal wire 1. The fine metal wire 1 is extracted downward through a guide 2 made of quartz and having a bore of a diameter of 30 µm. The leading end of the fine metal wire 1 reaches the space between the cutting blades 4a, 4b which are in separated state past the space between holding members 3a, 3b which also are in the separated state. A clamper denoted by 5a, 5b is disposed at the inlet side of the guide 2 so as to prevent the fine metal wire 1 moving naturally into the guide 2 (see Fig. 9a).

As the first step of the operation, the holding members 3a, 3b, made of ceramics, were brought together to pinch and fix the fine metal wire 1 from both sides thereof (see Fig. 9b). Subsequently, the clamper 5a, 5b was moved apart and the holding members 3a, 3b gripping the fine metal wire 1 were moved downward by a distance d. Razor blades were used as the cutting blades 4a, 4b. The cutting blades 4a, 4b were so constructed that they moved vertically as a unit with the holding members 3a, 3b. Thus, the cutting blades 4a, 4b were moved downward by the distance d as a result of the above-mentioned downward movement of the holding members 3a, 3b (see Fig. 9c). As a result of the above-described operation, the fine metal wire was extracted by the length d from the guide 2.

The clamper 5a, 5b was then closed and the cutting blades 4a, 4b were activated to move horizontally to cut the fine metal wire 1 (see Fig. 9d). The cutting blades 4a, 4b were reset to the waiting positions immediately after the cutting and the holding members 3a, 3b were moved apart so as to release the fine metal wire 1 thereby allowing the severed wire chip 10 to drop (see Fig. 9e). Finally, the holding members 3a, 3b and the cutting blades 4a, 4b were moved upward as a unit by a distance d (see Fig. 9f), thus recovering the initial state shown in Fig. 9a. It is thus possible to successively severe wire chips of a constant length d by cyclically conducting the steps shown in Figs. 9a to 9f. Tests were conducted by employing different distances d, i.e., 0.3 mm, 0.5 mm and 0.8 mm. In each case, the cutting could be done with a small error within ±0.1 mm.

### Working Example 2

In Working Example 1 described above, the clamper 5a, 5b has a role to prevent the fine metal wire from being naturally moved into or out of the guide when the holding members 3a, 3b which clamp the fine metal wire at the guide outlet are set to the releasing positions. This role, however, may be performed by a suitable means other than the clamper used in Working Example 1.

In Working Example 2, the guide 21 has a spiral form so as to play also the role of the clamper. The holding members 3a, 3b and the cutting blades 4a, 4b were the same as those used in Working Example 1. According to this arrangement, a certain resistance is produced by the wall of the spiral guide 21 when the fine metal wire 1 is fed through the guide 21, so that the extracted fine metal wire is stationed at the extracted position. Consequently, cutting was effected with a high precision as in Working Example 1, despite the absence of the clamper.

### Working Example 3

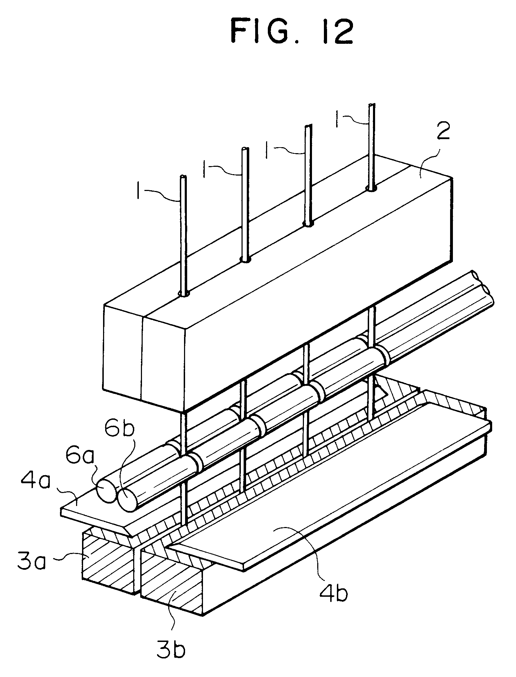

Fig. 11 is a schematic illustration of the apparatus used in this Example. Numeral 1 denotes a fine metal wire. 2 denotes a guide, 3a, 3b denote holding members and 4a, 4b denote cutting blades. Feed rolls 6a, 6b were placed on the outlet side of the guide 2. The feed rolls 6a, 6b, made of ceramics and having a diameter of 3 mm, were placed at a position which is 10 mm spaced from the outlet end of the guide 2. The feed rolls were driven by stepper motors which are not shown, so as to intermittently extract the fine metal wire at a constant length from the outlet end of the guide 2. In this Working Example, the portion of the fine metal wire to be cut is automatically moved to the position of the fine metal wire, so that there is no need for the holding members 3a, 3b and the cutting blades 4a, 4b to be moved vertically. The feed rolls rotate by an angle corresponding to one step so as to extract the leading end portion of the fine metal wire 1, while both the holding members 3a, 3b and the cutting blades 4a, 4b are in their spaced positions. Then, the holding members 3a, 3b are brought together to fix the end of the fine metal wire and then the cutting blades 4a, 4b are moved horizontally thereby cutting the fine metal wire 1. Cutting could be done by this method with a high degree of precision, when conducted on a gold wire of 30 µm dia. as the fine metal wire 1 at a cutting length of 0.4 mm.

### Working Example 4

The method of the fourth embodiment is for cutting an independent fine metal wire at a high precision. In order to improve the cutting efficiency, it is possible to combine a plurality of cutting elements for a plurality of independent wires so as to simultaneously process the wires in a parallel fashion. Fig. 12 shows an example of such a system, arranged for simultaneously cutting four-fine metal wires. The guide 2 used in this Working Example is made of ceramics and has a split-type construction composed of two halves having complementary grooves which in cooperation define a passage for the fine metal wire when these halves are brought together. The feed rolls 6a, 6b also are made of ceramics and are grooved to guide the fine metal wire straight. The rolls are driven by stepper motors which are not shown so that four fine metal wires 1 are extracted at one by an equal length.

The holding members 3a, 3b, as well as the cutting blades 4a, 4b, can simultaneously act on the four fine metal wires. The feed rolls are rotated while the wires are freed from the holding members and the cutting blades, thereby extracting the fine metal wires by a predetermined length. Then, the holding members are actuated to fix the ends of the fine metal wires, followed by activation of the cutting blades 4a, 4b for cutting the fine metal wires.

Gold wires of 20 m dia. were uniformly cut into wire chips of 0.9 mm long by the described method.

According to this embodiment, fine metal wires can be cut precisely without causing the fine metal wires to contact any impurity. In addition, the cut wire chips can be taken out in a separated state, thus facilitating delivery to the subsequent melting step.

### [Fifth Embodiment]

Materials of bumps are mainly soft metals. Wires formed from a bump material is generally so flexible that it is undesirably bent by the force of gravity, making it difficult to handle. In order to enhance the precision of the cutting length, it is necessary that the flexural metal wire be fed precisely at a predetermined pitch. It is, however, extremely difficult to precisely feed a fine wire of a soft metal having an extremely small diameter of several tens of microns and about 10 microns at the smallest.

The fifth embodiment has been accomplished in view of the above-described problem. Thus, the fifth embodiment provides a method which enables a fine metal wire to be cut efficiently and precisely into wire chips of a predetermined length and which is different from those used in the first to fourth embodiments.

The method of the fifth embodiment has the steps of: providing a first roll having a plurality of cutting edges formed at a constant circumferential pitch, a second roll contacted by the first roll, and a guide portion between the first and second rolls for cutting a fine metal wire; and rotatingly driving at least one of the first and second rolls so as to clamp and pull the fine metal wire into the nip between the first and second rolls, thereby cutting the fine metal wire by the cutting edges.

The second roll may have an outer peripheral surface region made of an elastic material.

In this embodiment, the fine metal wire guided by the guide portion is clamped by and pulled into the nip between both rolls, so that the wire can be precisely advanced even when it is highly flexible. In addition, it becomes possible to cut the fine metal wire precisely into metal wire chips of a predetermined length by designing the first roll such that the pitch of the cutting edges is equal to the cutting length. The second roll, when provided with peripheral surface region made of an elastic material, can grip and pull the fine metal wire with enhanced frictional force.

### Working Example 1

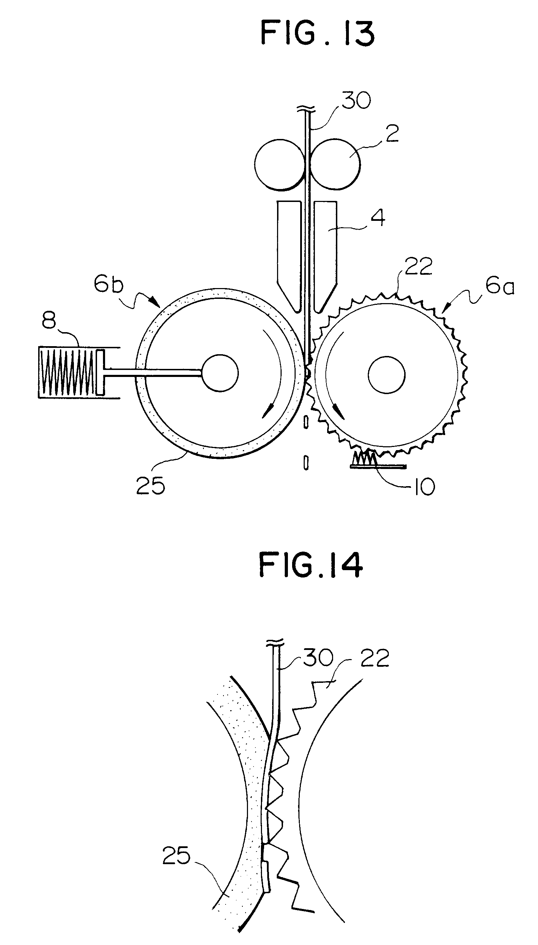

The fifth embodiment of the present invention will be described in more detail with specific reference to Figs. 13 and 14. Fig. 13 is a schematic illustration of an arrangement for conducting cutting step for cutting a fine metal wire in the fifth embodiment, while Fig. 14 is a schematic enlarged view of rollers during cutting of a fine metal wire by the cutting arrangement shown in Fig. 14. In this embodiment a gold wire of 20 m diameter is used as the fine metal wire.

The cutting step for cutting a fine metal wire in the Working Example 1 is conducted by a cutting arrangement which includes feed rolls 2 for feeding forward the fine metal wire 30, a guide 4 made of quartz and having a fine bore of 30 µm dia. and a pair of rolls 6a, 6b arranged below the guide 4.

A metallic cutting roll 6a (first roll) has a multiplicity of cutting edges 22 which are arranged at a constant circumferential pitch as shown in Fig. 13. The pitch of the cutting edges 22 is determined by the size of spherical bumps to be obtained and the diameter of the fine metal wire used as the material. In this Working Example, the pitch of the cutting edges is set to be 0.85 mm, in order to form spherical bumps of 80 µm diameter from a gold wire of 20 mm in diameter.

The pressing roll (second roll) 6b has an outer peripheral surface region made of an elastic material denoted by 25. This elastic material is used in order to increase the frictional attraction force so as to easily and securely attract the fine metal wire 30. The pressing roll 6b is provided with a cutting load adjusting mechanism 8. This mechanism is adapted for adjusting the pressure of contact between the cutting roll 6a and the pressing roll 6b. The axial thickness of the rolls 6a, 6b (measured in the direction perpendicular to the drawing sheet of Fig. 1) may be as small as about 2 since the diameter of the fine metal wire is very small. The diameters of these rolls 6a, 6b may be about 10 mm or so.

In general, cutting of a fine metal wire into chips of a predetermined length by feeding the wire forward by feed rolls alone encounters with a problem in that the feed cannot be conducted at a high precision due to bend of the fine metal wire. The feed folls 2 of Working Example 1 are intended for initially loading the guide portion 4 with the fine metal wire 30 in the initial setting of the apparatus. Thus, the feed rolls 2 merely support the fine metal wire 30 and do not positively feed the same during operation of the apparatus. In this Working Example, the extraction of the fine metal wire 30 is effected by the pair of rolls 6a, 6b as will be understood from the following description. Thus, the feed rolls 2 are not indispensable.

For cutting the fine metal wire 30 by the arrangement of Working Example 1, the leading end of the fine metal wire 30 is threaded through the nip between the feed rolls 2 and the feed rolls 2 are driven by, for example, stepper motors which are not shown, so that the fine metal wire 30 is introduced into the minute bore in the guide 4. The fine metal wire is therefore guided into the nip between both rolls 6a, 6b through the guide 4. Subsequently, both rolls 6a, 6b are driven by a driving device which is not shown. Consequently, the fine metal wire 30 is clamped by and attracted into the nip between the rolls 6a, 6b. In this Working Example, the outer peripheral region of the pressing roll 6b is formed of an elastic material 25, so that the fine metal wire can be clamped and attracted without any risk of breakage. In addition, a large frictional attraction force is developed to pull the fine metal wire into the nip between these rolls 6a, 6b, so that the fine metal wire 30 can be fed precisely without any slip. When the fine metal wire 30 has reached a position on a line which interconnects the centers of both rolls 6a, 6b, the force exerted by the cutting edge 22 on the fine metal wire 30 and the elastic material is maximized so as to cut the fine metal wire 30. It is thus possible to pull the fine metal wire 30 and cut the same precisely at a constant pitch (pitch of the cutting blades), simply by driving the rolls 6a, 6b.

The described Working Example 1 employs a cleaning device 10 having a brush or a nozzle and disposed under the cutting roll 6a. The cleaning device 10 removes any residue of the metal, e.g., gold, accumulated on the cutting edges 22 during continuous cutting, thereby preventing the cutting edges from becoming dull, thus ensuring high cutting precision while avoiding any inferior cutting.

According to the described Working Example 1, one (shown by 6b) of the roll has a peripheral surface region made of an elastic material, while the other roll 6a has cutting edges arranged at a constant pitch. It is therefore possible to stably attract the fine metal wire into the nip between these rolls by the frictional force and to cut the into chips of a constant length with a high precision. In addition, the length of cutting of the fine metal wire can be varied by varying the pitch of the cutting edges. In addition, the speed of cutting of the fine metal wire can be increased since the mechanical action is only to rotatingly drive the rolls.

The metal wire chips formed by the process of Working Example 1 are molten in the subsequent melting step so as to be formed into spherical bumps. In the melting step, it is necessary that the independent metal wire strips are molten without being interfered by one another.

When the described process for cutting the fine metal wires is adopted, the severed metal wire chips are allowed to drop onto a conveyor device such as a conveyor (not shown) disposed beneath the rolls, so that the severed metal wire chips are successively arrayed on the conveyor at a substantially constant interval, thus enabling a continuous supply of the wire chips from the cutting step to the subsequent melting step.

### Working Example 2

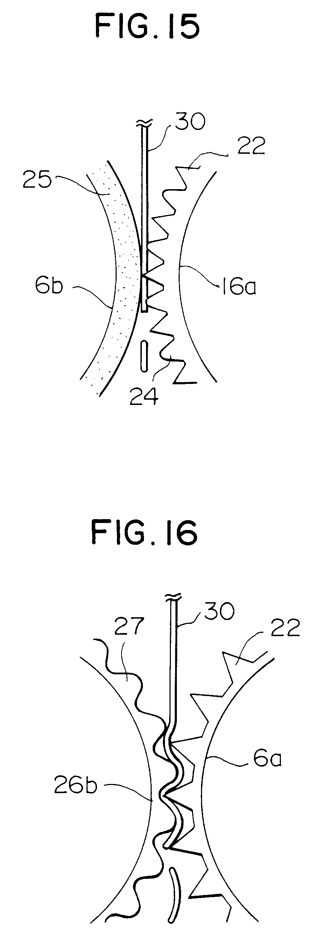

Fig. 15 is schematic enlarged view of rollers cutting a fine metal wire in accordance with a cutting method of a Working Example 2 of this embodiment. The Working Example 2 is discriminated from the Working Example 2 in that the cutting roll 16a of the Working Example 2 is provided with pressing teeth 24 arranged alternately with the cutting edges 22. Each pressing tooth 24 has a rounded edge which serves to attract the fine metal wire 30 in cooperation with the elastic member 25. In the Working Example 2, therefore, it is possible to clamp and attract the fine metal wire 30 with a greater frictional force than in the Working Example 1, by virtue of the cooperation between the rounded pressing teeth 24 and the elastic material 25.

From the view point of the production of the pressing roll 16, it is not easy to realize such a small pitch of cutting edges 22 as in Working Example 1, because the cutting edges 22 are formed alternately with the pressing teeth 24. The Working Example 2, therefore, is suitable for use in the case where the fine metal wire 30 is cut at a comparatively large cutting pitch. For instance, when spherical bumps of a diameter around 120 m are to be formed, the fine metal wire 30 should be cut at a pitch of 2.8 mm if the diameter of the wire 30 is 20 µm as in the case of Working Example 1. The cutting rolls 16 having such a comparatively large pitch can be produced without difficulty. Other points of operation and advantages are the same as those of Working Example 1.

### Working Example 3

Fig. 16 is a schematic enlarged view of rolls cutting a fine metal wire in accordance with a cutting step of Working Example 3 of this embodiment. The Working Example 3 is different from Working Example 1 only in that the outer peripheral surface of the pressing roll 26b is corrugated to provide pressing teeth 27 so that the fine metal wire 30 can be attracted into the nip between the rollers 6a, 26b by a greater frictional traction force than in Working Example 1. In Working Example 3, the rollers 6a and 26b are rotated with the corrugated pressing teeth 27 meshing with the cutting edges 22, so that the arc length of the tooth 27 determines the length of cutting of the fine metal wire 30. The corrugated pressing teeth 27 may be made of an ordinary metal or of an elastic material.

In the cutting step for cutting fine metal wire in Working Example 3, the fine metal wire 30 is pulled into the nip between the rolls along an arcuate path. This Working Example is therefore suitable for use in the cases where materials which are flexural but resistant to tearing when flexed, e.g., copper, are used as the materials of the fine metal wires 30.

In the foregoing description of Working Example 3, the cutting operation was explained with reference to a case where a single fine metal wire is cut. This, however, is only illustrative and the described Working Example may be modified to cut two or more fine metal wires simultaneously. Needless to say, in such a modification, it is necessary to correspondingly increase the axial thicknesses of the rolls.

As has been described, in the fifth embodiment of the present invention, it is possible to continuously cut a fine metal wire with a high degree of precision of the cutting length by a simple mechanism including a pair of rolls one of which is provided with peripheral cutting edges formed at a predetermined pitch. It is thus possible to obtain a cutting method for cutting fine metal wire, capable of improving the production efficiency.

### [Sixth Embodiment]

In the first embodiment described before, the spheroidizing step which is the second critical feature of the method of the present invention is conducted by arraying the fine metal chips cut in a constant length from the bump material wire with suitable spacing from one another, melting the wire chips and then solidifying the same so as to form spherical bumps by making use of the surface tension of the melt.

Thus, in the first embodiment of the method of the present invention for producing fine metal spheres, the chips of a constant length cut from a fine metal wire are arrayed on a crucible at a predetermined spacing and are molten in this state. This constant spacing is necessary to avoid merging of melts of adjacent cut wire chips which may occur when the melting step is conducted without leaving sufficient space between adjacent cut wire chips. This method can produce fine metal spheres with a high degree of uniformity of size provided that the chips are cut from the fine metal wire at a constant length. The metal wire chips, however, are very minute, 2 to 3 mm in length at the greatest, so that laborious work is necessary for arraying these chips, as well as for collecting the formed fine metal spheres.

In view of this fact, a sixth embodiment of the present invention provides a spheroidizing step which can improve the efficiency of the work with a simple device.

The spheroidizing step adopted in the sixth embodiment is characterized by the use of a vertically oriented furnace core tube arranged in the heating means. The cut metal wire chips are allowed to freely fall through the furnace core tube so as to be heated to a temperature above the melting point, whereby the metal wire chips are molten and spheroidized. Preferably, a lid is provided on the bottom of the reactor core tube.

According to this arrangement, a heating means heats the metal wire chips to a temperature above the melting point thereby melting these chips while the chips are freely falling in the furnace core tube. The metal in molten state exhibits a large surface tension so as to be spheroidized by itself, so that the metal wire chips are formed into fine metal spheres during dropping freely through the furnace core tube.

The lid on the bottom of the furnace core tube effectively prevents generation of an ascending flow of air through this tube.

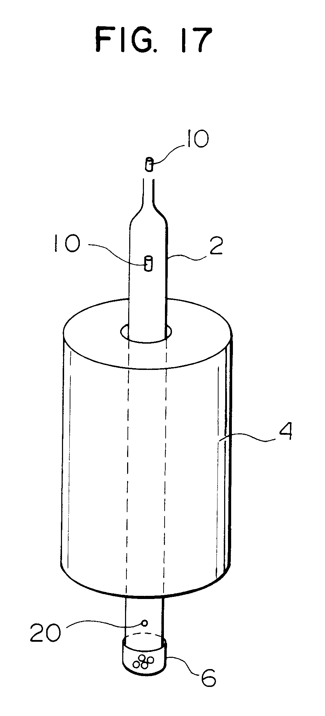

A working example of the present embodiment will be described below with reference to the accompanying drawing. Fig. 17 is a schematic diagram of an apparatus used in this working example. In this working example, a gold wire chip (metal wire chip) having a wire diameter of 25 µm, and a length of 0.55 mm is used and a gold sphere (fine metal sphere) having a diameter of 80 µm is manufactured.

The apparatus shown in Fig. 17 has a furnace core tube 2 serving as a passage through which a metal wire chip 10 falls, a heating furnace 4 for melting the metal wire chip 10, and a lid 6 for collecting fine metal spheres 20 formed. A quartz glass having an inside diameter of about 5 mm and a length of about 1000 mm was used as the furnace core tube 2, and a vertical ring type electric furnace having a length of 500 mm was used as the heating furnace 4. The heating furnace 4 had a temperature distribution such as to have a maximum temperature in the vicinity of its lower end. The maximum temperature in the heating furnace 4 was 1300°C. The maximum temperature of the heating furnace 4 was set to be higher than the melting point of gold in order to positively heat up the metal wire chip freely falling to a temperature higher than the melting point. The lid 6 is formed of quartz glass and is fitted to the lower end of the furnace core tube 2. The lid 6 serves to present occurrence of an upward air flow caused by the high-temperature heating furnace 4 and to collect fine metal spheres solidified. The distance between the heating furnace 4 and the lid was about 200 mm. Ordinary atmosphere air was supplied to the interior of the furnace core tube 2.

A metal wire chip 10 cut by a fine metal wire cutter (not shown) was made to fall from above the furnace core tube 2 to enter the furnace core tube 2. When the metal wire chip 10 entered the heating furnace 4 by falling in the furnace core tube 2, the temperature of the metal wire chip 10 was abruptly increased. The metal wire chip was melted when the temperature thereof became higher than the melting point of the metal. Ordinarily, metals change in shape in a molten state to become spherical by themselves because the surface tension thereof is large. The shape of the molten metal was therefore changed into a spherical shape during passage through the heating furnace 4. When the molten metal came out of the heating furnace 4, the temperature was abruptly reduced and the metal started solidifying. Finally, a metal sphere fell to the lid 6. Fine metal spheres 20 solidified and formed uniformly and completely were thereby obtained.

According to the method of manufacturing a fine metal piece in accordance with this working example, no apparatus for transporting the metal wire chip is provided and the metal wire chip can only be put into the furnace core tube, immediately followed by the step of collecting the fine metal sphere. The working efficiency and the mass-productivity can therefore be improved. The apparatus for this working example may have, for example, a unit for cutting a fine metal wire to form wire chips one by one at regular intervals which unit is provided above the furnace core tube of this embodiment, thereby making it possible to continuously conduct the step of cutting the fine metal wire, the step of spheroidizing the cut metal wire chip and the step of collecting the fine metal sphere.

The fine metal manufacture process in accordance with this embodiment can be applied for metals or alloys which have not been adopted. It is thereby possible to manufacture fine metal spheres having a composition suitable for bumps at an improved efficiency.

In an working example, a gold sphere is manufactured by using a gold wire chip. However, the present invention is not limited to this; other metals suitable for bumps may also be used. Ordinarily, the speed at which the metal wire chip passes through the heating furnace can be known from the initial falling speed. Also, the necessary length of the heating furnace and the maximum temperature thereof are determined from the size of the metal wire chip and the melting point of the metal. Accordingly, it is necessary to change the sizes of the furnace core tube and the heating furnace, the temperature of the heating furnace and other factors if the fine metal sphere is manufactured from a different metal. In other case of some metals, it is necessary to replace the atmosphere in the furnace tube with a special gas atmosphere to prevent chemical reaction in the high-temperature heating furnace.

In the above-described working example, the lid is fitted to the lower end of the furnace core tube. However, the present invention is not limited to this arrangement. For example, instead of using the lid, a lower end portion of the furnace core tube may be worked so as to be tapered, and fine metal spheres may be collected through a lower end opening. A belt conveyor or the like, for example, may also be disposed under the furnace core tube to continuously collect fine metal spheres.

According to this embodiment, as described above, a fine metal sphere can easily be manufactured by melting a freely falling metal wire chip with a heating means and by utilizing the large surface tension of the molten metal. It is therefore possible to provide a spheroidizing process which can be improved in working efficiency and, hence, in mass-productivity by a simple apparatus.

### [Seventh Embodiment]

In this embodiment, a spheroidizing process is provided which can be improved in working efficiency and in mass-productivity and which is different from that of the sixth embodiment.

The spheroidizing process for forming fine metal spheres in accordance with this embodiment is characterized in that a metal wire chip transported by a transport means is melted by being heated up to a temperature higher than the melting point of the metal used to form the metal wire chip and is thereby spheroidized.

In this embodiment, based on the above arrangement, the metal wire chip is transported by the transport means and is melted by being heated up to a temperature higher than the melting point of the metal of the metal wire chip during transportation. The surface tension of the molten metal is so large that the molten metal changes in shape to become spherical by itself. The metal wire chip is therefore formed into the shape of a fine metal sphere during transportation.

### Working Example 1

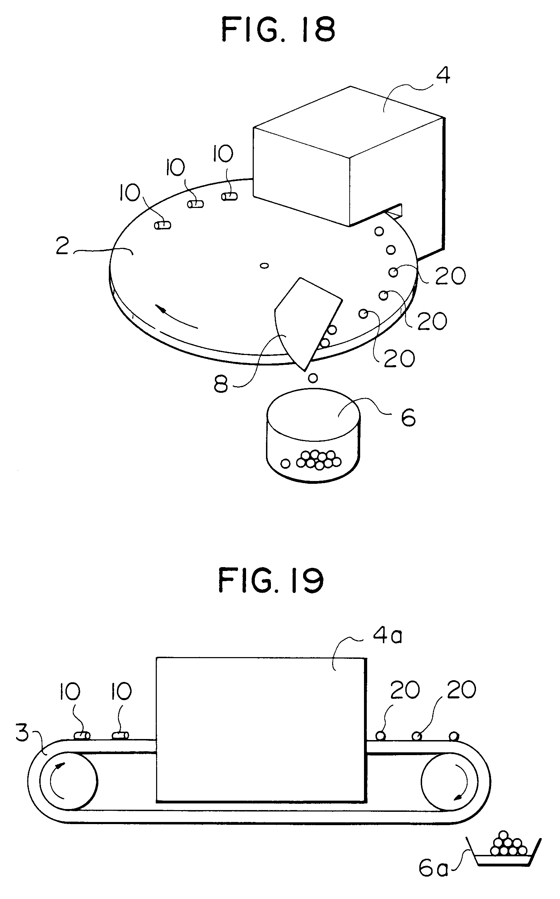

A first working example of this embodiment will be described below with reference to Fig. 18. Fig. 18 is a schematic diagram of an apparatus used for the fine metal sphere manufacture process. In this working example, a gold wire chip (metal wire chip) having a wire diameter of 25 µm, and a length of 0.55 mm is used and a gold sphere (fine metal sphere) having a diameter of 80 µm is manufactured.

The apparatus shown in Fig. 18 has a heat resistant turn table 2 for transporting metal wire chips 10, a motor (not shown) for driving the turn table 2, a generally U-shaped heating furnace 4 for melting the metal wire chips 10, a collecting container 6 for collecting fine metal spheres 20 formed, and a guide 8 for making the fine metal spheres 20 on the turn table 2 fall into the collecting container 6. The turn table 2 is formed of a ceramic and has a circular shape and a diameter of about 200 mm. The maximum temperature in the heating furnace 4 is set to 1200°C slightly higher than the melting point of gold (1060°C).

Each metal wire chip 10 cut by a fine metal wire cutter (not shown) is placed on the turn table 2. The metal wire chip 10 is rotated together with the turn table 2, and its temperature starts rising abruptly when the metal wire chip 10 enters the heating furnace 4. The metal wire chip is melted when the temperature becomes higher than the melting point of the metal. Ordinarily, metals change in shape to become spherical by themselves in a molten state because the surface tension thereof is large. The shape of the molten metal is therefore changed into a spherical shape during passage through the heating furnace 4. When the molten metal comes out of the heating furnace 4, the temperature is abruptly reduced and the metal starts solidifying. Finally, a metal sphere is made by the guide 8 to fall into the collecting container 6. Fine metal spheres 20 are thus obtained.

To melt the meal wire chip with certain reliability, there is a need for changing the turn table speed according to the heating capacity of the heating furnace.

The inventors of the present invention actually made an experiment using the above-described apparatus and metal wire chip, and fine metal spheres having a spherical shape formed uniformly and completely were thereby obtained.

Thus, in the fine metal sphere manufacture process in accordance with this working example, the metal wire chip is only placed on the turn table, and the process thereafter automatically proceeds to the step of collecting the fine metal sphere. The working efficiency and the mass-productivity can therefore be improved. Further, the apparatus for this working example may have, for example, a unit for cutting a fine metal wire to form wire chips one by one at regular intervals which unit is provided above the turn table, thereby making it possible to continuously conduct the step of cutting the fine metal wire, the step of spheroidizing the cut metal wire chip and the step of collecting the fine metal sphere.

The fine metal manufacture method in accordance with this working example 1 can be applied for metals or alloys which have not been adopted. It is thereby possible to easily manufacture fine metal spheres having a composition suitable for bumps at an improved efficiency.

### Working Example 2

A second working example will be described below with reference to Fig. 19. Fig. 19 is a schematic diagram of an apparatus used in accordance with the fine metal sphere manufacture method. The material and the size of the metal wire chip used are the same as those of the first working example.

The apparatus shown in Fig. 19 has a belt conveyor for transporting metal wire chips 10, a motor (not shown) for driving the belt conveyor 3, a tunnel type heating furnace 4a for melting the metal wire chips 10, and a collecting container 6a for collecting fine metal spheres 20 formed. The belt conveyor 3 must have suitable resistance to heat since it passes through the heating furnace 4a. For the belt conveyor 3, therefore, a belt formed of a heat resistant steel chains on which a multiplicity of small ceramic trays are mounted is used.

Each metal wire chip 10 cut by a fine metal wire cutter (not shown) is made to fall softly from, for example, above the belt conveyor 3. The metal wire chip 10 is transported by the belt conveyor 3, and its temperature starts rising abruptly when the metal wire chip 10 enters the heating furnace 4a. The metal wire chip 10 is melted so that its shape is changed into a spherical shape when the temperature becomes higher than the melting point of the metal. When metal wire chip comes out of the heating furance 4a, the temperature is abruptly reduced and the metal starts solidifying. Finally, a metal sphere falls from the belt conveyor 3 to be collected in the collecting container 6. Fine metal spheres 20 formed uniformly and completely were obtained.

In the above-described first and second working examples, a gold sphere is manufactured by using a gold wire chip. However, the present invention is not limited to this; a different metal suitable for bumps may also be used. In such a case, since the melting point differs according to the kind of metal, it is necessary to correspondingly set the maximum temperature of the heating furnace and changing the material of the turn table or the belt conveyor as well as the speed thereof. Also, in the case of some metal, it is necessary to replace the atmosphere in the heating furnace 4 with a special gas atmosphere to prevent chemical reaction in the high-temperature heating furnace 4.

According to this embodiment, as described above, a fine metal sphere can easily be manufactured by melting a metal wire chip transported by the transport means by using the heating means and by utilizing the large surface tension of the molten metal. It is therefore possible to provide a spheroidizing method which can be improved in working efficiency and, hence, in mass-productivity.

### [Eighth Embodiment 8]

In the eighth embodiment, a high-energy beam is used instead of the heating/melting means used in the seventh embodiment.

The process of spheroidizing metal wire chips in the fine metal sphere manufacture method in accordance with the eighth embodiment is characterized by comprising a step of disposing metal wire chips having a certain length on a transport means while spacing them apart, and a step of irradiating each metal wire chip with a high-energy beam during metal wire transport process so that the metal wire chip is heated up to a temperature higher than the melting point of the metal wire chip to be melted.

In this embodiment, based on the above arrangement, each of metal wire chips is irradiated with a high-energy beam to be melted so that it is heated up to a temperature higher than the melting temperature of the metal. The molten metal, which has a large surface tension, changes in shape to become spherical by itself, i.e., to become a fine metal sphere.

Also, a light condenser means may be used to reduce the minimum spot diameter of the high-energy beam so that the fine metal wire chip can be irradiated at a high efficiency.

### Working Example

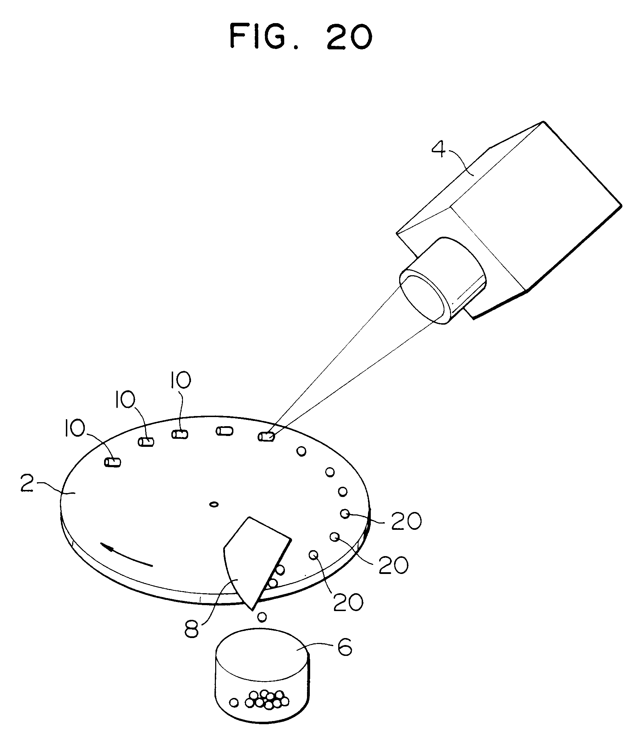

A working example of this embodiment will be described below with reference to the accompanying drawing. Fig. 20 is a schematic diagram of an appartus used in this embodiment. In this working example, a gold wire chip (metal wire chip) having a wire diameter of 25 µm, and a length of 0.55 mm was used and a gold sphere (fine metal sphere) having a diameter of 80 µm was manufactured.

The apparatus shown in Fig. 20 has a heat resistant turn table 2 for transporting metal wire chips 10, a motor (not shown) for driving the turn table 2, a high-energy beam irradiation unit 4 for irradiating each metal wire chip, a collecting container 6 for collecting fine metal spheres 20 formed, and a guide 8 for making the fine metal spheres 20 on the turn table 2 fall into the collecting container 6. The turn table 2 is formed of a ceramic and has a circular shape and a diameter of about 200 mm. In this method, the heated region is smaller in comparison with other methods, and it is not necessary to form the whole of the turn table 2 in ceramic. For example, only a doughnut-like portion on which metal wire chips are placed may be formed of a ceramic.

A high-luminance xenon lamp is used as a beam source for the high-energy beam irradiation unit 4 (e.g., a beam spot welder). The high-energy beam irradiation unit may incorporate a light condensing device having a concave mirror or a convex lens to further condense the high-energy beam. The object can be heated up to 2000°C at the maximum by the high-energy beam irradiation unit 4.

To form fine metal spheres 20, metal wire chips 10 cut by a fine metal wire cutter (not shown) were first placed on the turn table 2, and the turn table 2 was driven to move each metal wire chip 10 to a high-energy beam irradiation position. Next, the metal wire chip 10 was irradiated with the high-energy beam to be melted so that it was heated up to a temperature higher than the melting point of the metal. Ordinarily, molten metals have a large surface tension and can change in shape in a molten state to become spherical by themselves. Accordingly, the shape of the molten metal was changed into a spherical shape while it was being irradiated with the high-energy beam. The metal melted and formed into the spherical shape was moved out of the high-energy beam irradiation range by the turn table 2, and the next metal wire chip was moved to the high-energy beam irradiation range. The metal formed into the spherical shape was gradually cooled and solidified to be formed as a fine metal sphere 20 having a diameter of 80 µm. On the other hand, the next metal wire chip was irradiated with the high-energy beam. Thus, the metal wire chips placed on the turn table 2 were successively heated and melted. Finally, fine metal spheres 20 thereby formed were made by the guide 8 to fall into the collecting container 6, thereby being collected.

If a high-energy beam formed by condensation using a light condensing device having a lens or the like is used, each metal wire chip can be irradiated with the high-energy beam condensed. Fine metal wire chips could therefore be melted in a short time so that it may be heated at an improved efficiency by concentrated energy.

Thus, according to the fine metal sphere manufacture method of this embodiment, the metal wire chip is only placed on the turn table, and the process thereafter automatically proceeds to the step of collecting the fine metal sphere. The working efficiency and the mass-productivity can therefore be improved. Further, the apparatus for this working example may have, for example, a unit for cutting a fine metal wire to form wire chips one by one at regular intervals which unit is provided above the turn table of this embodiment, thereby making it possible to continuously conduct the step of cutting the fine metal wire, the step of spheroidizing the cut metal wire chip and the step of collecting the fine metal sphere.

Also, the method of this embodiment can be applied for metals or alloys which have not been adopted. It is thereby possible to easily manufacture fine metal spheres having a composition suitable for bumps at an improved efficiency. If fine metal spheres are manufactured by using other metals, it is necessary to change the heating temperature and the turn table speed with respect to metals used, since the melting points differs with respect to the metals. Also, according to the metal used, heating may be effected in a special gas atmosphere in order to prevent chemical reaction at a high temperature.

In the above-described embodiment, a xenon lamp is used as the high-energy beam source, but the present invention is not limited to this. Alternatively, a laser, an infrared radiation heater or the like may be used as the high-energy beam source. An infrared irradiation unit using an infrared radiation heater is specifically suitable for melting a low-melting-point metal used for a soldering material, because the maximum temperature of the infrared radiation heater is about 1200°C.

Also, in the above-described embodiment, a turn table is used as the metal wire chip transport means, but the present invention is not limited to this, and a belt conveyor may alternatively be used. In this case, needless to say, the belt conveyor must be formed of materials superior in resistance to heat. For example, to form the belt conveyor, the belt may be formed of heat resistant steel chains, and a multiplicity of small ceramic trays may be mounted on the belt.

According to this embodiment, as described above, a fine metal sphere can easily be manufactured by irradiating a metal wire chip with a high-energy beam so that the metal wire chip is melted and by utilizing the large surface tension of the molten metal. It is therefore possible to provide a fine metal sphere manufacture method which can be improved in working efficiency and, hence, in mass-productivity.

### [Ninth Embodiment]

In the methods of producing fine metal spheres of the seventh and eighth embodiments, a fine metal wire is cut into metal wire chips having a predetermined length, which have to be then arranged manually one by one at equal spaces on a melting pan or the like.

While there may be a variety of means available for arranging fine metal chips, including the ones described above, it is desirable, in not a few cases, that the step of cutting the metal wire into chips and that of fusing them into fine metal spheres be, if possible, unified, depending on the scale on which the fine metal spheres are produced.

This embodiment has been made in view of the above situation. It provides a method of producing fine metal spheres which helps to enhance the operational efficiency and which allows mass production with ease.

The method of producing fine metal spheres in accordance with this ninth embodiment is characterized in that, after stretching a fine metal wire on the upper surface of a heat-resistant base plate on which recesses are formed, the stretched fine metal wire is heated to melt, thereby making it possible to effect the cutting of the fine metal wire and the spheroidizing thereof simultaneously to obtain fine metal spheres.

It is desirable that the above-mentioned base plate be equipped with a number of recesses whose size is uniform at least in terms of the recess openings over which the fine metal wire is stretched.

Further, it is desirable that the fine metal wire be heated to melt after placing a heat-resistant presser lid upon the upper surface of the above-mentioned base plate, on which the fine metal wire is stretched.

In this embodiment, with the construction described above, a fine metal wire stretched on the upper surface of the base plate is heated to cut it by fusion into metal chips having a length corresponding to the size of the recesses, and these metal chips obtained by fusion are retained on the recess bottoms so as to spheroidize them by utilizing the surface tension inherent in molten metal. Afterwards, they are allowed to calmly cool off to solidify so as to be formed into fine metal spheres.

Since the above-mentioned base plate has a number of recesses whose size is uniform at least in terms of the openings over which a fine metal wire is stretched, all the metal wire chips obtained by fusion have the same length, thus making it possible to mass-produce fine metal spheres having the same size with ease.

Further, by heating the fine metal wire to melt it after placing the heat-resistant presser lid upon the upper surface of the above-mentioned base plate, on which the fine metal wire is stretched, any deviation of the fusing positions, caused by the deformation of the metal wire chips due to the thermal expansion as a result of heating the fine metal wire, can be prevented. Further, if, in the case where a large number of openings are formed on the base plate, some variation occurs in terms of the time at which the fusion takes place at the different recesses, the fine metal wire can be reliably fused for each recess.

### Working Example

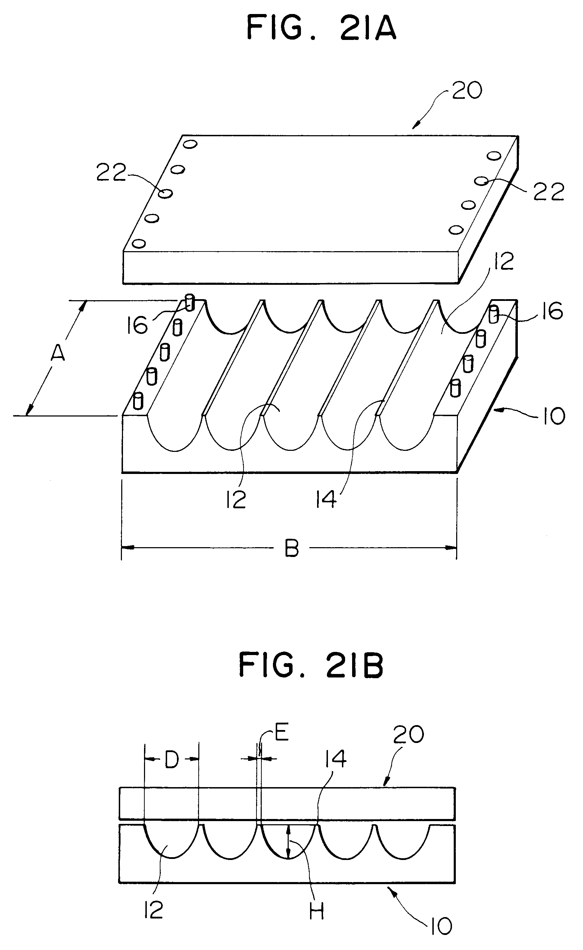

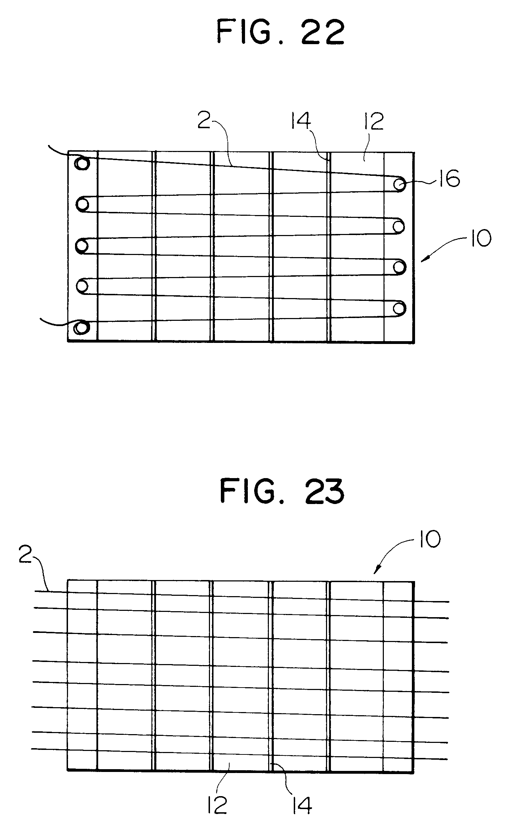

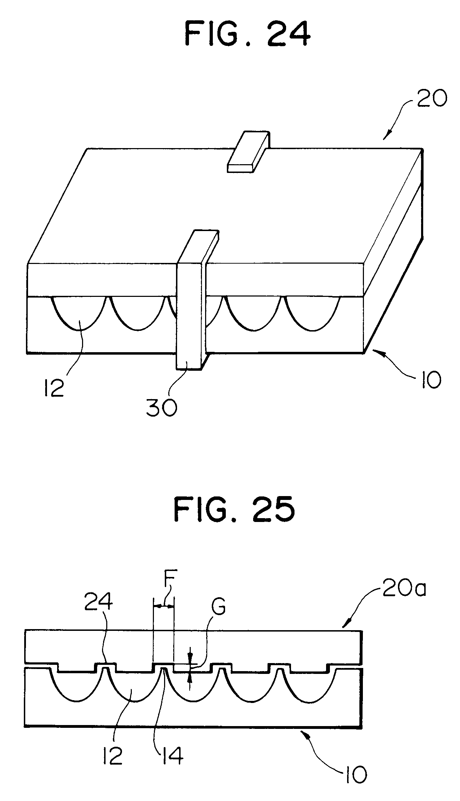

In the following, a working example of this embodiment will be described with reference to Figs. 21A to 24. Fig. 21A(a) is a schematic diagram showing the base plate and the presser lid used in an embodiment of this invention; Fig. 21B is a schematic side view showing the base plate and the presser lid mated with each other; Figs. 22 and 23 are diagrams for illustrating methods of stretching (a) fine metal wire(s) on the base plate; and Fig. 24 is a schematic diagram showing the base plate on which the fine metal wire(s) is(are) stretched and the presser lid when they are firmly attached to each other. In this working example, a gold wire (fine metal wire) having a diameter of 20 µm was used to produce gold spheres (fine metal spheres) having a diameter of 80 µm.

Formed on the heat-resistant base plate 10 shown in Figs. 21A(a) and 21B are a number of grooves (recesses) 12 having a fixed width. It is desirable that the base plate 10 be formed of a heat-resistant material such as carbon or ceramics. The dimension of the base plate 10, which is not particularly limited, was 30 mm in length (A) and 50 mm in width (B). The section of each groove 12 had a semi-spherical configuration; the width D of the opening of each groove 12 was 0.8 mm; the width E of each of protrusions 14 provided between the grooves 12 was 0.1 mm; and the depth H of each groove 12 was 0.35 mm. Actually, the configuration of the grooves 12 is not limited to any particular type; instead of a semi-spherical one, the configuration of the section of each groove 12 may be a square or a V-shaped one. When its section has a V-shaped configuration, however, the bottom portion thereof has to be rounded at 0.05 mm radius or more. Further, it is desirable that the width E of the inter-groove protrusions 14 be as small as possible.

The width D of the opening of each groove is determined by the diameter of the fine metal wire and the size of the fine metal spheres to be produced. In the case of this working example, the forming of the grooves with an accuracy of ±0.1 mm in the size of their widths results in the variation of about 10% or less regarding the length of the fused metal wire chips and the error in the radius when formed into metal spheres was approximately 5% or less, thus making it possible to produce uniform fine metal spheres with high accuracy. Accordingly, when fusing a fine metal wire described below, no great influence occurs on the accuracy in the metal spheres obtained no matter into which one of adjacent grooves a gold wire portion disposed just upon an groove protrusion 14 may drop. Further, a number of pins 16 were provided on both ends of the base plate 10, at a space substantially equal to the pin diameter, with each of the pins 16 on one end being arranged to have a position corresponding to another position defined between adjacent two pins disposed on the other end. By virtue of this arrangement, a fine metal wire can be stretched substantially in parallel on the upper surface of the base plate 10.

The presser lid 20, which was also made of a ceramic material, was placed on the base plate 10, thereby serving to fix the fine metal wire 2 which was stretched over the grooves 12. The surface of the presser lid 20 facing the base plate 10 was machined to be flat. Further, in the presser lid 20 were provided holes 22 corresponding to the pins 16. It is desirable that the gap between the base plate 10 and the presser lid 20 when they are put together be as small as possible. The base plate 10 and the presser lid 20 were finished so that the gap width ranged from 0 to 10 µm at the most. The fine metal wire 2 was sandwiched between the base plate 10 and the presser lid 20 thus finished, thereby fixing the fine metal wire.

To produce fine metal spheres, the fine metal wire 2 was first stretched on the upper surface of the base plate 10 in such a manner that it extended perpendicular to the grooves 12. In this working example, the fine metal wire 2 was, as shown in Fig. 22, sequentially disposed round the pins 16 provided on both ends of the base plate 10, thereby stretching the fine metal wire on the upper surface of the base plate 10. Further, as shown in Fig. 23, it is also possible to provide no pins on the base plate 10, arranging a plurality of fine metal wires 2 in parallel. In the case where a plurality of fine metal wires 2 are thus arranged, the employment of the presser lid 20 for fixing the fine metal wire 2 is of particular significance.

After stretching the fine metal wire (gold wire) 2 on the base plate 10, the presser lid 20 was placed on the base plate 10, fixing it by a fixing member 30 such as a clamp or a hinge, as shown in Fig. 24. In this condition, the base plate was put, for example, in an induction heater, melting the gold wire at 1060°C. Simultaneously with its melting, the gold wire was cut by fusion into wire chips at the protrusions 14 between the grooves 12, the wire chips dropping into the grooves 12. In this embodiment, the width D of the grooves 12 was 0.8 mm, so that each of the gold wire chips was 0.8 mm long. Thus, the gold wire chips obtained by the fusion were arranged in the grooves, at an appropriate interval (approximately equal to the diameter of the pins 16).

Generally, molten metal has a large surface tension, so that, when a fine solid piece thereof is heated at a temperature not lower than its melting point, it tends to become spherical of itself when in a molten state. Accordingly, a fine metal sphere could be produced solely by melting a metal piece having a mass identical to that of the metal sphere to be obtained and by allowing it to calmly cool off to solidify.

Accordingly, the metal wire chips arranged at fixed spaces in the grooves 12 melted in the furnace and were formed into fine metal spheres of a uniform size. Finally, the base plate 10 was taken out of the furnace and was allowed to cool off slowly, thereby obtaining fine metal spheres having the size desired.

Thus, in the method of producing fine metal spheres of this embodiment, the step of cutting the fine metal wire and that of melting the metal wire chips can be unified, so that the operation of arranging the metal wire chips after the cutting is not necessary, thus enhancing the operational efficiency in the process of producing fine metal spheres. Further, by forming a large number of grooves 12 or forming them long, an improvement could be attained in terms of mass-productivity.

Further, this embodiment adopts a heat-resistant material for the base plate 10 and the presser lid 20, which means, once produced, these components can be used semi-permanently.

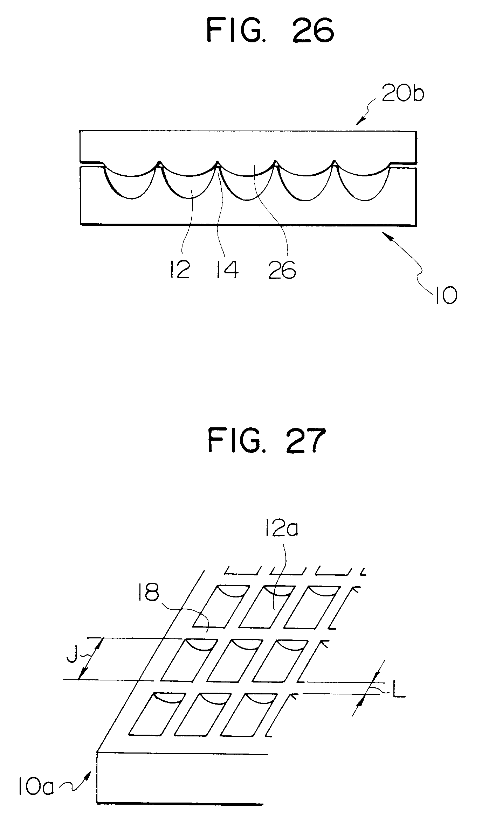

Figs. 25 and 26 show other examples of the presser lid used in this embodiment. The presser lid 20a shown in Fig. 25 had recesses 24 with a width F of 0.2 mm and a depth G of 0.1 mm, which recesses were formed in those sections corresponding to the protrusions 14 between the grooves 12 of the base plate 10. In a case where the presser lid 20a was formed in this way, no mechanical finishing was needed regarding the surface of the presser lid portions extended between the recesses 24, thus facilitating the machining of the presser lid 20a.

The presser lid 20b shown in Fig. 26 was formed such that the surface portion facing the base plate 10 had an undulated configuration. The convex portions 26 of the undulation had a configuration corresponding to the grooves 12 of the base plate 10. When the presser lid 20b shown in Fig. 26 was used, the fine metal wire was pressed downwards, during the fusing operation, at the respective central portions of the grooves 12 by the presser lid 20b, so that the fine metal wire could be reliably cut, at the time of fusion, at the protrusions 14, thereby uniformalizing the size of the metal wire chips obtained by the fusion.

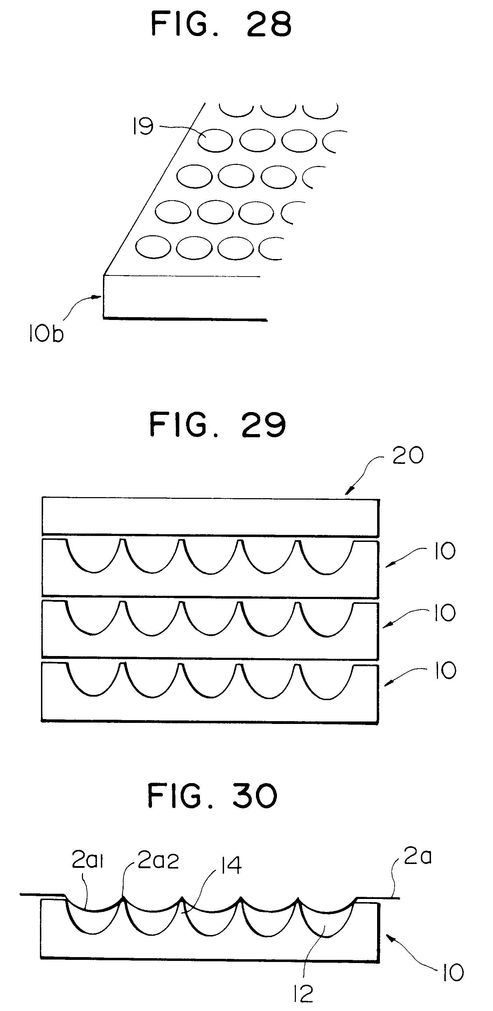

Figs. 27 and 28 show other examples of the base plate used in this embodiment. The base plate 10a shown in Fig. 27 was characterized by partitions 18, which were provided in the grooves 12 of the base plate 10 shown in Figs. 21 and 22, thereby dividing the grooves 12 into small chambers 12a having a length J of 4 mm. The thickness L of the partitions 18 was 1 mm. The base plate 10b shown in Fig. 28 was characterized in that, instead of grooves, it had holes 19 having a diameter M of approximately 4 mm. When the base plate shown in Fig. 27 or 28 was used, the fine metal wire chips obtained by fusing a fine metal wire dropped into the small chambers 12a or the holes 19, one chip into one chamber or one hole, so that no two or more metal wire chips were allowed to melt together, thus preventing any large-sized defective from being produced. Thus, by using the base plate shown in Fig. 27 or 28, an improvement could be attained in terms of yield.

Although the above embodiment has been described in connection with the case where a single base plate was used, it is also possible to stack a plurality of base plates one on top of the other. For example, as shown in Fig. 29, three base plates 10 may be stacked together before they are put in a heating furnace. In that case, however, the bottom surfaces of the top and the middle base plates 10 must be finished with the same level of accuracy as the presser lid. When the base plates 10 are thus used to have the function of the presser lid, the presser lid 20 has only to be placed on the uppermost base plate 10, so that the number of presser lids 20 can be reduced and a large quantity of fine metal spheres can be produced by a single treatment.

While the above embodiment has been described in connection with the case where the fine metal wire 2 is linear, this should not be construed as restrictive. For example, it may have an undulated configuration, as shown in Fig. 30, with the troughs 2a₁ of the undulation corresponding to the grooves 12. When fused, such a fine metal wire 2a is cut at the crests 2a₂, so that the protrusions 14 require no precision finish, thus facilitating the production of the base plate. In that case, however, the length of each metal wire chip obtained corresponds to the length of each arc of the undulation.

Further, while the above embodiment has been described in connection with the case where a presser lid is used when effecting fusion, the presser lid can be omitted if the fine metal wire has a configuration as shown in Fig. 30. Apart from this, it goes without saying that the presser lid can be omitted when the fine metal spheres do not particularly require precision.

Further, although the above embodiment has been described in connection with the case where the grooves and the holes of the base plate have a fixed size, this should not be construed as restrictive. It is also possible to form several types of grooves, holes, etc. of different sizes on a single base plate, thereby making it possible to produce fine metal spheres of different sizes by a single process.

As described above, in accordance with this embodiment, the cutting of a fine metal wire and the fusion of the metal wire chips obtained through the cutting can be effected by a single process by stretching the fine metal wire on the upper surface of a base plate and heating the base plate to a high temperature, thus providing a method of producing fine metal spheres which helps to attain an improvement in terms of the operational efficiency and mass-productivity in the process of producing fine metal spheres.

### INDUSTRIAL APPLICABILITY

As described above, this invention makes it possible to efficinetly produce fine metal spheres having a uniform size and a satisfactory configuration and involving no limitations in terms of purity and composition, so that the method of this invention can be applied to the production of fine metal spheres of a uniform size to be used as bumps required in the field of semiconductor packaging.

## Claims

1. A method of producing soft metal spheres or soft alloy spheres comprising the steps of preparing soft metal or alloy fine wire, cutting the wire into fine wire chips, arranging the fine wire chips in a spaced state to each other, heating the fine wire chips up to a temperature above the melting point thereof so that the soft metal spheres or soft alloy spheres are formed from the fine wire chips, characterized in that each of the fine wire chips has a ratio of wire chip length to wire chip diameter in a range of 5 to 100.

2. Method according to claim 1, characterized in that the fine wire has a diameter not more than 100 µm.

3. Method according to claim 2, characterized by the steps of: feeding the fine wire by a predetermined length out of the outlet end of a guide having a fine internal bore; cutting said wire into fine wire chips by actuating a cutting device arranged in the close proximity of said outlet; arranging the fine wire chips so that the fine wire chips are not in contact with each other; and heating the fine wire chips to form said wire chips into said soft metal spheres or soft alloy spheres.

4. Method according to claim 2, characterized by the steps of: disposing both a guide (X) having a minute internal bore which allows the fine soft metal or alloy wire to pass therethrough and a guide (Y) having a fine internal bore of a diameter greater than that of said guide (X) so that said internal bores of said guides are aligned with each other; inserting said fine wire through said bores of the guides (X) and (Y) until the end of the fine wire is received by a predetermined length in said bore of said guide (Y), causing a relative movement between said guide (X) and (Y) so as to shear the fine wire into wire chips; arranging the wire chips so that the wire chips are not in contact with each other; and heating the wire chips to form them into the soft metal spheres or soft alloy spheres.

5. Method according to claim 2, characterized by the steps of: holding the end of the soft metal or alloy wire by a holding device; moving the holding device to extract said fine wire from a guide by a predetermined length; cutting said fine wire into fine wire chips by a cutting device disposed in close proximity of said holding device; arranging the fine wire chips so that the fine wire chips are not in contact with each other; and heating the fine wire chips to form them into the soft metal spheres or soft alloy spheres.

6. Method according to claim 2, characterized by the steps of: extracting the soft metal or soft alloy fine wire by a predetermined length out of a guide by means of feed rolls arranged on the outlet side of said guide; cutting said fine wire into fine wire chips by means of a cutting device disposed in close proximity of said feed rolls; arranging the fine wire chips so that the fine wire chips are not in contact with each other; and heating the fine wire chips to form them into the soft metal spheres or the soft alloy spheres.

7. Method according to claim 2, characterized by the steps of:
arranging a cutting device having a first roll provided with a plurality of cutting edges disposed at a predetermined circumferential pitch, a second roll in contact with said first roll, and a guide portion for guiding the fine wire between said first and second rolls; driving at least one of said first roll and said second roll so as to clamp and tract the fine soft metal or soft alloy wire into the nip between said first and second rolls to thereby cut said fine wire into fine wire chips by said cutting edges; arranging the fine wire chips so that the fine wire chips are not in contact with each other; and heating the fine wire chips to form them into the soft metal spheres or soft alloy spheres.

8. Method according to claim 6, wherein the outer periphery of said second roll is formed of an elastic material.

9. Method according to any of the preceding claims, characterized by the steps of: preparing soft metal or alloy fine wire chips each having a predetermined length and having a diameter not more than 100 µm; arranging the fine wire chips in a spaced state each other; and conveying said fine wire chips through a heating means to thereby heat said wire chips to a temperature above the melting point thereof so as to melt said wire chips.

10. Method according to claim 2, characterized by comprising the steps of stretching a soft metal or alloy fine wire on the top surface of a heat-resistant base plate having a recess at said top surface, and heating the stretched fine wire to a temperature above the melting point so as to melt said fine wire so that the cutting and spheroidizing of the fine wire are effected simultaneously.

11. Method according to claim 10, wherein said base plate has a plurality of said recesses, at least the openings of the recesses over which the fine wire having a diameter not more than 100 µm is stretched being made to have an equal size.

12. Method according to the claim 10 or 11, wherein said fine wire is heated and melted after a pressing cover is placed on the top surface of said base plate on which said fine wire having a diameter not more than 100 µm is stretched.

## Patentansprüche

1. Verfahren zur Herstellung von Weichmetallkugeln oder Weichlegierungskugeln mit den folgenden Schritten: Bereitstellen von feinem Weichmetall- oder -legierungsdraht, Schneiden des Drahts in feine Drahtspäne, Anordnen der feinen Drahtspäne in einem beabstandeten Zustand voneinander, Erwärmen der feinen Drahtspäne auf eine Temperatur über ihrem Schmelzpunkt, so daß die Weichmetallkugeln oder Weichlegierungskugeln aus den feinen Drahtspänen gebildet werden, dadurch gekennzeichnet, daß jeder der feinen Drahtspäne ein Verhältnis von Drahtspanlänge zu Drahtspandurchmesser in einem Bereich von 5 bis 100 hat.

2. Verfahren nach Anspruch 1, dadurch gekennzeichnet, daß der feine Draht einen Durchmesser von höchstens 100 µm hat.

3. Verfahren nach Anspruch 2, gekennzeichnet durch die folgenden Schritte: Zuführen des feinen Drahts über eine vorbestimmte Länge aus dem Auslaßende einer Führung mit einer feinen Innenbohrung; Schneiden des Drahts in feine Drahtspäne durch Betätigen einer in enger Nachbarschaft zu dem Auslaß angeordneten Schneidvorrichtung; Anordnen der feinen Drahtspäne, so daß die feinen Drahtspäne nicht miteinander in Berührung stehen; und Erwärmen der feinen Drahtspäne, um die Drahtspäne zu den Weichmetallkugeln oder Weichlegierungskugeln zu formen.

4. Verfahren nach Anspruch 2, gekennzeichnet durch die folgenden Schritte: Anordnen sowohl einer Führung (X) mit einer winzigen Innenbohrung, durch die der feine Weichmetall- oder -legierungsdraht verlaufen kann, als auch einer Führung (Y) mit einer feinen Innenbohrung mit einem größeren Durchmesser als dem der Führung (X), so daß die Innenbohrungen der Führungen zueinander ausgerichtet sind; Einführen des feinen Drahts durch die Bohrungen der Führungen (X) und (Y), bis das Ende des feinen Drahts über eine vorbestimmte Länge in der Bohrung der Führung (Y) aufgenommen ist; Bewirken einer Relativbewegung zwischen den Führungen (X) und (Y), um den feinen Draht in Drahtspäne zu scheren; Anordnen der Drahtspäne, so daß die Drahtspäne nicht miteinander in Berührung stehen; und Erwärmen der Drahtspäne, um sie zu den Weichmetallkugeln oder Weichlegierungskugeln zu formen.

5. Verfahren nach Anspruch 2, gekennzeichnet durch die folgenden Schritte: Halten des Endes des Weichmetall- oder -legierungsdrahts durch eine Haltevorrichtung; Bewegen der Haltevorrichtung, um den feinen Draht über eine vorbestimmte Länge aus einer Führung herauszuziehen; Schneiden des feinen Drahts in feine Drahtspäne durch eine in enger Nachbarschaft zu der Haltevorrichtung angeordnete Schneidvorrichtung; Anordnen der feinen Drahtspäne, so daß die feinen Drahtspäne nicht miteinander in Berührung stehen; und Erwärmen der feinen Drahtspäne, um sie zu den Weichmetallkugeln oder Weichlegierungskugeln zu formen.

6. Verfahren nach Anspruch 2, gekennzeichnet durch die folgenden Schritte: Herausziehen des feinen Weichmetall- oder Weichlegierungsdrahts über eine vorbestimmte Länge aus einer Führung durch an der Auslaßseite der Führung angeordnete Zufuhrwalzen; Schneiden des feinen Drahts in feine Drahtspäne durch eine in enger Nachbarschaft zu den Zufuhrwalzen angeordnete Schneidvorrichtung; Anordnen der feinen Drahtspäne, so daß die feinen Drahtspäne nicht miteinander in Berührung stehen; und Erwärmen der feinen Drahtspäne, um sie zu den Weichmetallkugeln oder Weichlegierungskugeln zu formen.

7. Verfahren nach Anspruch 2, gekennzeichnet durch die folgenden Schritte: Anordnen einer Schneidvorrichtung mit einer ersten Walze, die mit mehreren in einer vorbestimmten Umfangsteilung angeordneten Schneidkanten versehen ist, einer mit der ersten Walze in Berührung stehenden zweiten Walze und einem Führungsabschnitt zum Führen des feinen Drahts zwischen der ersten und zweiten Walze; Antreiben der ersten Walze und/oder der zweiten Walze, um den feinen Weichmetall- oder Weichlegierungsdraht einzuspannen und in den Spalt zwischen der ersten und zweiten Walze zu ziehen, um dadurch den feinen Draht durch die Schneidkanten in feine Drahtspäne zu schneiden; Anordnen der feinen Drahtspäne, so daß die feinen Drahtspäne nicht miteinander in Berührung stehen; und Erwärmen der feinen Drahtspäne, um sie zu den Weichmetallkugeln oder Weichlegierungskugeln zu formen.

8. Verfahren nach Anspruch 6, wobei der Außenumfang der zweiten Walze aus einem elastischen Material gebildet ist.

9. Verfahren nach einem der vorstehenden Ansprüche, gekennzeichnet durch die folgenden Schritte: Bereitstellen feiner Weichmetall- oder -legierungsdrahtspäne, die jeweils eine vorbestimmte Länge und einen Durchmesser von höchstens 100 µm haben; Anordnen der feinen Drahtspäne in einem beabstandeten Zustand voneinander; und Transportieren der feinen Drahtspäne durch eine Erwärmungseinrichtung, um dadurch die Drahtspäne auf eine Temperatur über ihrem Schmelzpunkt zu erwärmen, um die Drahtspäne zu schmelzen.

10. Verfahren nach Anspruch 2, gekennzeichnet durch die folgenden Schritte: Spannen eines feinen Weichmetall- oder -legierungsdrahts auf der Oberseite einer wärmebeständigen Grundplatte mit einer Auskehlung auf der Oberseite und Erwärmen des gespannten feinen Drahts auf eine Temperatur über dem Schmelzpunkt, um den feinen Draht zu schmelzen, so daß das Schneiden und die Kugelbildung des feinen Drahts gleichzeitig erfolgen.

11. Verfahren nach Anspruch 10, wobei die Grundplatte mehrere der Auskehlungen hat und mindestens die Öffnungen der Auskehlungen, über denen der feine Draht mit einem Durchmesser von höchstens 100 µm gespannt ist, in gleicher Größe hergestellt sind.

12. Verfahren nach Anspruch 10 oder 11, wobei der feine Draht erwärmt und geschmolzen wird, nachdem eine Preßabdeckung auf die Oberseite der Grundplatte gelegt wird, auf der der feine Draht mit einem Durchmesser von höchstens 100 µm gespannt ist.

## Revendications

1. Procédé de production de sphères d'un métal tendre ou de sphères d'un alliage tendre, comprenant des étapes de préparation d'un fil fin de métal tendre ou d'alliage de métal tendre, de coupe du fil en morceaux de fil fin, de disposition des morceaux de fil fin afin qu'ils soient espacés les uns des autres, et de chauffage des morceaux de fil fin à une température supérieure à leur température de fusion afin que des sphères de métal tendre ou d'alliage tendre se forment à partir des morceaux de fil fin, caractérisé en ce que chacun des morceaux de fil fin présente un rapport de sa longueur à son diamètre compris entre 5 et 100.

2. Procédé selon la revendication 1, caractérisé en ce que le fil fin a un diamètre qui ne dépasse pas 100 µm.

3. Procédé selon la revendication 2, caractérisé en ce qu'il comprend les étapes suivantes : la transmission du fil fin d'une longueur prédéterminée à l'extrémité de sortie d'un guide ayant un trou interne de petite dimension, la coupe du fil en morceaux de fil fin par commande d'un dispositif de coupe placé très près de la sortie, la disposition des morceaux de fil fin de manière que ces morceaux ne soient pas en contact mutuel, et le chauffage des morceaux de fil fin pour la formation de sphères de métal tendre ou d'alliage tendre à partir de ces morceaux.

4. Procédé selon la revendication 2, caractérisé en ce qu'il comprend les étapes suivantes : la disposition à la fois d'un guide (X) ayant un minuscule trou interne qui permet le passage du fil fin d'alliage ou de métal tendre et d'un guide (Y) ayant un petit trou interne dont le diamètre est supérieur à celui du guide (X) afin que les trous internes des guides soient alignés, l'insertion du fil fin dans les trous des guides (X) et (Y) jusqu'à ce que l'extrémité du fil fin soit logée sur une longueur prédéterminée dans le trou du guide (Y), le déplacement relatif des guides (X) et (Y) afin que le fil fin soit cisaillé en morceaux de fil, la disposition des morceaux de fil afin qu'ils ne soient pas en contact mutuel, et le chauffage des morceaux de fil afin qu'ils forment des sphères de métal tendre ou d'alliage tendre.

5. Procédé selon la revendication 2, caractérisé par les étapes suivantes : le maintien du fil de métal tendre ou d'alliage tendre par un dispositif de maintien, le déplacement du dispositif de maintien afin qu'il extraie le fil fin d'un guide sur une longueur prédéterminée, la coupe du fil fin en morceaux de fil fin par un dispositif de coupe placé très près du dispositif de maintien, la disposition des morceaux de fil fin afin que ces morceaux ne soient pas en contact mutuel, et le chauffage des morceaux de fil fin afin qu'ils forment des sphères de métal tendre ou d'alliage tendre.

6. Procédé selon la revendication 2, caractérisé en ce qu'il comprend les étapes suivantes : l'extraction du fil fin de métal tendre ou d'alliage tendre sur une longueur prédéterminée en dehors d'un guide à l'aide de cylindres d'avance placés du côté de sortie du guide, la coupe du fil fin en morceaux de fil fin à l'aide d'un dispositif de coupe placé très près des cylindres d'avance, la disposition des morceaux de fil fin de manière que les morceaux de fil fin ne soient pas en contact mutuel, et le chauffage des morceaux de fil fin afin qu'ils forment des sphères de métal tendre ou d'alliage tendre.

7. Procédé selon la revendication 2, caractérise par les étapes suivantes : la disposition d'un appareil de coupe ayant un premier cylindre muni de plusieurs bords de coupe avec un pas circonférentiel prédéterminé, un second cylindre placé au contact du premier cylindre, et une partie de guidage du fil fin entre les premier et second cylindres, l'entraînement du premier cylindre et du second cylindre au moins afin qu'ils serrent et tirent le fil fin de métal tendre ou d'alliage tendre dans l'emprise formée par le premier et le second cylindre afin que le fil fin soit coupé ainsi en morceaux par les bords de coupe, la disposition des morceaux de fil fin afin que ces morceaux ne soient pas en contact mutuel, et le chauffage des morceaux de fil fin afin qu'ils forment des sphères de métal tendre ou d'alliage tendre.

8. Procédé selon la revendication 6, dans lequel la périphérie externe du second cylindre est formée d'un matériau élastique.

9. Procédé selon l'une quelconque des revendications précédentes, caractérisé par les étapes suivantes : la préparation de morceaux de fil fin de métal tendre ou d'alliage tendre ayant une longueur prédéterminée et un diamètre qui ne dépasse pas 100 µm, la disposition des morceaux de fil fin à distance les uns des autres, et le transport des morceaux de fil fin dans un dispositif de chauffage afin que les morceaux de fil fin soient chauffés à une température supérieure à leur température de fusion si bien que les morceaux de fil fondent.

10. Procédé selon la revendication 2, caractérisé en ce qu'il comprend des étapes d'étirage d'un fil fin d'un métal tendre ou d'un alliage tendre à la surface supérieure d'une plaque réfractaire de base ayant une cavité à sa face supérieure, et de chauffage du fil fin étiré à une température supérieure à la température de fusion afin que le fil fin fonde si bien que la coupe et la sphéroïdisation du fil fin sont réalisées simultanément.

11. Procédé selon la revendication 10, dans lequel la plaque de base a plusieurs cavités, les ouvertures au moins des cavités sur lesquelles est tendu le fil fin dont le diamètre ne dépasse pas 100 µm étant réalisées avec des dimensions égales.

12. Procédé selon la revendication 10 ou 11, dans lequel le fil fin est chauffé et fondu après disposition d'un couvercle de pression à la surface supérieure de la plaque de base sur laquelle est tendu le fil fin ayant un diamètre qui ne dépasse pas 100 µm.
